# EUROPÄISCHE PATENTANMELDUNG

(11) **EP 4 279 444 A1**
(43) Veröffentlichungstag der Anmeldung: **22.11.2023**
(21) Anmeldenummer: 22174041.8
(22) Anmeldetag: 18.05.2022
(51) Int. Cl.: B81B 3/00

(54) **MEMS-AKTUATOR, INSBESONDERE MIKROSPIEGEL, MIT ERHÖHTER AUSLENKBARKEIT**

(71) Anmelder: Hahn-Schickard-Gesellschaft für angewandte Forschung e.V., 78052 Villingen-Schwenningen (DE)
(72) Erfinder: Rockstroh, Jan, 78112 St. Georgen (DE); Bittner, Achim, 74080 Heilbronn (DE); Hoffmann, Daniel, 78089 Unterkirchnach (DE); Dehé, Alfons, 72770 Reutlingen (DE)
(74) Vertreter: Hertin und Partner Rechts- und Patentanwälte PartG mbB

(57) **Zusammenfassung**

Die Erfindung betrifft einen MEMS-Aktuator umfassend eine Rahmenstruktur und mindestens einen Aktuatorarm. Der Aktuatorarm ist an einem ersten Ende mit der Rahmenstruktur und an einem zweiten Ende mit einem Aktuatorkörper verbunden. Der MEMS-Aktuator zeichnet sich dadurch aus, dass der mindestens eine Aktuatorarm eine Mäanderstruktur umfassend zwei oder mehr Aktuatorabschnitte aufweist. Die zwei oder mehr Aktuatorabschnitte sind im Wesentlichen senkrecht zur Längsachse des Aktuatorarms ausgerichtet. Des Weiteren umfassen die zwei oder mehr Aktuatorabschnitte mindestens eine Lage aus einem Aktuatormaterial, wobei durch eine Ansteuerung der zwei oder mehr Aktuatorabschnitte eine Bewegung des Aktuatorkörpers bewirkbar ist.

Weiterhin betrifft die Erfindung ein Verfahren zur Herstellung des erfindungsgemäßen MEMS-Aktuators.

## Beschreibung

Die Erfindung betrifft einen MEMS-Aktuator umfassend eine Rahmenstruktur und mindestens einen Aktuatorarm. Der Aktuatorarm ist an einem ersten Ende mit der Rahmenstruktur und an einem zweiten Ende mit einem Aktuatorkörper verbunden. Der MEMS-Aktuator zeichnet sich dadurch aus, dass der mindestens eine Aktuatorarm eine Mäanderstruktur umfassend zwei oder mehr Aktuatorabschnitte aufweist. Die zwei oder mehr Aktuatorabschnitte sind im Wesentlichen senkrecht zur Längsachse des Aktuatorarms ausgerichtet. Des Weiteren umfassen die zwei oder mehr Aktuatorabschnitte mindestens eine Lage aus einem Aktuatormaterial, wobei durch eine Ansteuerung der zwei oder mehr Aktuatorabschnitte eine Bewegung des Aktuatorkörpers bewirkbar ist.

Weiterhin betrifft die Erfindung ein Verfahren zur Herstellung des erfindungsgemäßen MEMS-Aktuators.

### Hintergrund und Stand der Technik

Für die Herstellung kompakter, mechanisch-elektronischer Vorrichtungen wird heute auf vielen Anwendungsgebieten auf die Mikrosystemtechnik zurückgegriffen. Die so herstellbaren Mikrosysteme (englisch: micro electro mechanical system, kurz MEMS) sind sehr kompakt (ca. im Mikrometerbereich) bei gleichzeitig hervorragender Funktionalität und immer geringeren Herstellungskosten.

Aus dem Stand der Technik sind auch Aktuatoren bekannt, die auf Wirkungsprinzipien und/oder Herstellungsmethoden der Mikrosystemtechnik basieren. Aktuatoren (auch als Aktoren bekannt) bezeichnen allgemein Baukomponenten, die ein Steuersignal, z. B. in Form eines elektrischen Steuersignals, in mechanische Bewegungen und/oder Veränderungen physikalischer Größen umsetzen, wie z. B. eines Druckes und/oder einer Temperatur. Aktuatoren im Kontext der Mikrosystemtechnik werden auch als MEMS-Aktuatoren bezeichnet.

In Algamili et al. (2021) wird eine Übersicht über Bau- und Funktionsweisen von bekannten MEMS-Aktuatoren des Standes der Technik offenbart. MEMS-Aktuatoren können nach verschiedensten Kriterien klassifiziert werden, insbesondere nach ihrem Wirkungsprinzip. So sind MEMS-Aktuatoren bekannt, die nach elektrostatischen, piezoelektrischen, elektromagnetischen oder thermischen Prinzipien arbeiten. Bei den ersten drei Prinzipien wird typischerweise elektrische Energie direkt in mechanische Energie umgesetzt. Beim thermischen (Antriebs-)Prinzip wird die elektrische Energie zunächst in thermische Energie umgewandelt, woraufhin aufgrund der Wärmeausdehnung die Umwandlung in mechanische Energie folgt.

MEMS-Aktuatoren weisen eine hohe Zahl an Anwendungsbereichen auf. Beispielsweise können MEMS-Aktuatoren dazu genutzt werden, einen damit verbundenen Mikrospiegel zu bewegen und/oder auf eine gewünschte Stellung zu positionieren. Mikrospiegel finden auf vielen Gebieten Einsatz. Unter anderem werden Mikrospiegel in der Automobiltechnik im Kontext von LiDAR eingesetzt, was für den englischen Ausdruck Light Detection and Ranging steht und eine Methode zur Distanzmessung sowie Umfelderkennung darstellt. Dabei werden Mikrospiegel verwandt, um Licht mit hoher Scangeschwindigkeit über große Winkelbereiche auf entsprechende Objekte zu emittieren und Distanzmessungen vorzunehmen. In Dingkang, Watkins & Xie (2020) wird auf die LiDAR-Technologie sowie auf die Anforderungen an Bau- und Funktionsarten von Mikrospiegeln für diese Anwendungen eingegangen.

Mikrospiegel sind besonders relevant im Kontext der Display- oder Projektionstechnik, beispielsweise der sogenannten DLP-Technologie, was für den englischen Ausdruck digital light processing steht. DLP findet beispielsweise für Videoprojektoren und Rückprojektionsbildschirme im Heimkino- und Präsentationsbereich Anwendung. DLP wird auch im industriellen Bereich für die additive Fertigung eingesetzt. Des Weiteren findet die Technologie Anwendung in der Biologie sowie in der Medizin für optische Untersuchungsmethoden. Katal, Tyagi & Joshi (2013) liefert eine Einführung in die DLP-Technologie und geht auf den Einsatz in (potentielle) Anwendungsgebiete ein.

Grundlage der DLP-Technologie ist das DMD (englisch: Digital Micromirror Device). Die Wirkungsweise von DMDs wird beispielsweise in Lee (2008) sowie dem grundlegenden Patent US 5,061,049 beschrieben. Ein DMD umfasst eine Vielzahl von Mikrospiegeln, die gemäß einem Array angeordnet sind, beispielsweise in Form einer Matrix in einem rechteckigen Feld. Jeder Mikrospiegel entspricht einem Pixel eines anzuzeigenden Bildes. Die Mikrospiegel können einzeln um ca. ± 10°-12° gedreht werden, um sie ein- oder auszuschalten. Im eingeschalteten Zustand wird das Licht einer Projektorlichtquelle in Richtung einer Optik, beispielsweise in eine Linse, derart reflektiert, dass die Pixel auf dem Bildschirm hell erscheinen. Im ausgeschalteten Zustand wird das Licht in eine andere Richtung gelenkt, wodurch das Pixel dunkel erscheint. Um beispielsweise Graustufen zu erzeugen, wird der Spiegel sehr schnell ein- und ausgeschaltet. Das Verhältnis von Einschaltzeit zu Ausschaltzeit bestimmt den Farbton des zu projizierenden Bildes. Um eine große Projektionsfläche beleuchten zu können, sind die möglichen Auslenkwinkel relevant. Für die Darstellung des Projektionsbildes als solche hat die Beweglichkeit des Mikrospiegels einen entscheidenden Einfluss.

Mikrospiegel werden auch als Komponenten von Mikroscannern benötigt (siehe z. B. Holmström, Baran & Urey (2014)). Je nach Bauart kann die modulierend wirkende Bewegung eines Mikrospiegels translatorisch oder um eine bzw. zwei Achsen rotatorisch erfolgen. Im ersten Fall wird eine phasenschiebende Wirkung erzielt, während im zweiten Fall die Ablenkung des einfallenden Lichtstrahls bewirkt wird. Mikroscanner können beispielsweise bei Laserdisplays oder Resonanzscanner Anwendung finden.

Laserdisplay-Anwendungen erfordern ebenfalls große Auslenkungen eines Spiegels in Verbindung mit hoher Bewegungspräzision. Resonanzscanner nutzen einen hohen mechanischen Qualitätsfaktor (Q), um den erforderlichen Winkel des Mikrospiegels zu erreichen. Bei Atmosphärendruck ist ein sehr hohes Antriebsmoment erforderlich, um die Luftdämpfung zu überwinden. Dieses Problem kann durch den Einsatz eines Vakuumpackages gelöst werden, was jedoch kostspielig ist und eine Reihe anderer technischer Probleme mit sich bringt.

Damit liegt im Stand der Technik insbesondere für die Bewegung von Mikrospiegeln der Bedarf vor, MEMS-Aktuatoren bereitzustellen, welche die Auslenkbarkeit sowie die Bewegung optimieren. Insbesondere sollte eine dynamische Auslenkung über einen großen Winkelbereich ermöglicht werden.

In Bezug auf einen Einsatz von Mikrospiegeln in Laserscanning- bzw. Projektionssystemen sollte beispielsweise eine verbesserte Auflösung über eine größere Bildfläche erzielt werden. Ebenso ist im Kontext von LiDAR -Systemen eine große Auslenkbarkeit der Mikrospiegel wünschenswert, um das Scan- bzw. Sichtfeld (englisch: field of view, FoV) zu erhöhen. Für selbstfahrende Autos sollte das minimal Sichtfeld bspw. mindestens 25° betragen, während für eine Gestenerkennung sogar 50° und für eine Blindspot-Detektion 120° oder mehr notwendig sind (siehe auch Watkins & Xie (2020)). Gleichzeitig müssen die Mikrospiegel hohen Anforderungen an die Präzision sowie Scangeschwindigkeit genügen.

Bei bekannten MEMS-Aktuatoren des Standes der Technik besteht mithin ein Bedarf an Verbesserung, die Aktuierung von Mikrospiegeln hinsichtlich der Auslenkung als solche sowie in Bezug auf die Dynamik zu verbessern, wobei es zudem wünschenswert wäre, hierzu geeignete MEMS-Aktuatoren mittels prozesseffizienter Verfahren bereitstellen zu können.

### Aufgabe der Erfindung

Aufgabe der Erfindung war es, einen MEMS-Aktuator bereitzustellen, der die Nachteile des Standes der Technik beseitigt. Insbesondere sollte ein MEMS-Aktuator bereitgestellt werden, mit dem große Auslenkungswinkel eines Aktuatorkörpers, beispielsweise eines Mikrospiegels, ermöglicht werden, vorzugsweise bei gleichzeitig hoher Bewegungspräzision und Dynamik. Des Weiteren sollte sich der MEMS-Aktuator vorzugsweise durch einen robusten, kompakten Aufbau und effektiveres Herstellungsverfahren auszeichnen.

### Zusammenfassung der Erfindung

Die erfindungsgemäße Aufgabe wird gelöst durch die unabhängigen Ansprüche. Vorteilhafte Ausgestaltungen der Erfindung sind in den abhängigen Ansprüchen offenbart.

In einem ersten Aspekt betrifft die Erfindung bevorzugt einen MEMS-Aktuator umfassend eine Rahmenstruktur und mindestens einen Aktuatorarm, wobei der Aktuatorarm an einem ersten Ende mit der Rahmenstruktur und an einem zweiten Ende mit einem Aktuatorkörper verbunden ist, dadurch gekennzeichnet, dass der mindestens eine Aktuatorarm eine Mäanderstruktur umfassend zwei oder mehr Aktuatorabschnitte aufweist, wobei die zwei oder mehr Aktuatorabschnitte im Wesentlichen senkrecht zu einer Längsachse des Aktuatorarms ausgerichtet sind und mindestens eine Lage aus einem Aktuatormaterial umfassen und wobei durch eine Ansteuerung der zwei oder mehr Aktuatorabschnitte eine Bewegung des Aktuatorkörpers bewirkbar ist.

Der bevorzugte MEMS-Aktuator hat sich in vielerlei Hinsicht als vorteilhaft erwiesen und zeigt deutliche Verbesserungen gegenüber dem Stand der Technik.

Ein besonderer Vorteil des bevorzugten MEMS-Aktuators ist der Effekt, dass hohe Auslenkungen des Aktuatorkörpers erzielt werden können. Die größeren Auslenkungen betreffen vorteilhaft alle räumlichen Dimensionen und können sich beispielsweise in hohen Kippwinkeln manifestieren. Hierbei bezeichnet der Kippwinkel bevorzugt einen Winkel bzw. eine Neigung, der bzw. die gegenüber einer Ausgangsposition des Aktuatorkörpers in vertikaler Richtung zur Längsachse des Aktuatorarms vorliegt. Generell ist es vorteilhaft möglich, besonders hohe Auslenkungen des Aktuatorkörpers zu erreichen, wobei eine Auslenkung hierbei bevorzugt eine Veränderung einer Ausgangsposition des Aktuatorkörpers meint.

Hohe Auslenkungen bzw. Kippwinkel des Aktuatorkörpers resultieren aus der Ausgestaltung des Aktuatorarms, wonach dieser eine Mäanderstruktur aufweist mit zwei oder mehr Aktuatorabschnitte, welche im Wesentlichen senkrecht zur Längsachse ausgerichtet sind.

Bei einer Ansteuerung des Aktuatorarms werden die zwei oder mehr Aktuatorabschnitte simultan angeregt, sodass sich deren Kraftwirkung zu einem größeren Moment bzw. Hub aufsummieren und eine höhere Auslenkbarkeit des Aktuatorkörpers bewirken. Vorteilhaft skaliert die gewünschte Auslenkbarkeit hierbei mit der Anzahl an Aktuatorabschnitte, welche entsprechend wählbar ist.

Die Erfinder haben erkannt, dass durch eine Mäanderstruktur umfassend zwei oder mehr Aktuatorabschnitte durch Summierung der Wirkung der einzelnen Aktuatorabschnitte ein höheres Moment einer Kraft für die Steuerung des Aktuatorkörpers generiert werden kann. Bevorzugt ist mit dem Moment einer Kraft ein Drehmoment gemeint, d. h. insbesondere das Produkt aus der Kraft und einer Strecke. Durch das Zusammenwirken einer Vielzahl von Aktuatorabschnitten ergibt sich in der Summe ein höheres Moment und damit eine höhere Auslenkbarkeit und/oder ein höherer Kippwinkel des Aktuatorkörpers.

Die Bereitstellung eines MEMS-Aktuators mit der Möglichkeit, höhere Kippwinkel zu erzielen, ist für eine Vielzahl von Anwendungen vorteilhaft. So ist im Stand der Technik das Bestreben bekannt, Mikrospiegel bereitzustellen, die über große Winkel präzise und schnell verkippt werden können, um beispielsweise in LiDAR-Systemen, der konfokalen Mikroskopie und/oder in Displays eingesetzt zu werden.

Durch die Ausbildung des Aktuatorkörper als Mikrospiegel, beispielsweise in dem dieser mindestens abschnittsweise eine reflektive Oberfläche aufweist, kann der erfindungsgemäße MEMS-Aktuator seine Vorteile auf diese Anwendungsmöglichkeiten besonders wirksam übertragen.

Ein weiterer Vorteil des bevorzugen MEMS-Aktuators stellt die Möglichkeit dar, dass der Aktuatorkörper in mehreren Raumrichtungen verkippbar ist. Insbesondere kann die Bewegung bzw. können die Bewegungsoptionen des Aktuatorkörpers für entsprechende Anwendungszwecke prozesseffizient angepasst werden, beispielsweise durch die Anbringung mehrerer Aktuatorarme und/oder von Fixierungselementen. Vorteilhaft erlaubt beispielsweise die Anbringung mehrerer Aktuatorarme an mehreren Stellen des Aktuatorkörpers eine Auslenkung in unterschiedliche Kipprichtungen, wie dies beispielsweise für zweidimensionale Bewegungen wünschenswert ist. Durch die Anbringung eines Fixierungselementes in Kombination mit einem oder mehreren Aktuatorarmen kann eine Auslenkung des Aktuatorkörpers entlang einer Achse oder eines Punktes in einer oder mehreren Kipprichtungen bewirkt werden.

Darüber hinaus kann der bevorzugte MEMS-Aktuator mit einer Vielzahl von Wirkungsweisen betrieben werden. So kann vorteilhaft ein potentieller Nutzer des bevorzugten MEMS-Aktuators ein Wirkungsprinzip aus einer Vielzahl von physikalischen Prinzipien auswählen, beispielsweise eine Ansteuerung durch ein elektrisch oder thermisches Signal, um die Bewegung des Aktuatorkörpers zu bewirken. Die Ausnutzung eines Aktuatorarmes mit einer Mäanderstruktur zur Bewegung des Aktuatorkörpers ist somit nicht auf bestimmte Aktuatorprinzipien beschränkt.

Ein weiterer Vorteil des bevorzugten MEMS-Aktuators ist dessen effiziente Herstellbarkeit. So ist der bevorzugte MEMS-Aktuator mit gängigen Methoden der Mikrosystem- und/oder Halbleitertechnik bereitstellbar, insbesondere die Strukturierung der Mäanderstruktur sowie die Ausgestaltung des Aktuatorarms. Besonders vorteilhaft ist, dass der bevorzugte MEMS-Aktuator aus einem Substrat und damit einer einzelnen Prozessabfolge hergestellt werden kann. Mithin ist die Herstellung des bevorzugten MEMS-Aktuators massentauglich sowie prozesseffizient und führt gleichzeitig zur Bereitstellung eines kompakten und robusten MEMS-Aktuators.

Im Sinne der Erfindung bezeichnet ein MEMS-Aktuator bevorzugt einen Aktuator, der Strukturen und/oder Komponenten mit Abmessungen im Mikrometerbereich aufweist und/oder mit Methoden der Halbleiter- und/oder Mikrosystemtechnik hergestellt wurde. Dabei ist der MEMS-Aktuator bevorzugt in der Lage, durch eine Ansteuerung, beispielsweise durch ein Steuersignal, in eine physikalische Größe und/oder in mechanische Energie, z. B. in kinetische und/oder potentielle Energie, umgewandelt zu werden. Vorzugsweise erfolgt dies durch eine Auslenkung des Aktuatorkörpers. Als strukturelle Komponenten umfasst der MEMS-Aktuator bevorzugt eine Rahmenstruktur, einen Aktuatorarm und einen Aktuatorkörper.

Die Rahmenstruktur bezeichnet bevorzugt einen Träger für den Aktuatorarm. Bei der Rahmenstruktur handelt es sich bevorzugt um eine Struktur, welche im Wesentlichen durch eine durchgehende äußere Umrandung in Form von Seitenwänden eines freibleibenden flächigen Bereichs gebildet wird. Die Rahmenstruktur ist dabei bevorzugt stabil und biegesteif. Bei einer eckigen Rahmenform (dreieckiger, viereckiger, sechseckig oder allgemein mehreckiger Umriss) können die einzelnen Seitenbereiche, die die Rahmenstruktur im Wesentlichen bilden, auch als Seitenwände bezeichnet werden. Insbesondere kann an der Rahmenstruktur der Aktuatorarm verbunden vorliegen.

Der Aktuatorarm bezeichnet bevorzugt diejenige Komponente des MEMS-Aktuators, durch die eine Auslenkung des Aktuatorkörpers ermöglicht wird. Insbesondere ist der Aktuatorarm ein Verbindungsglied zwischen dem Aktuatorkörper und der Rahmenstruktur. Dabei weist der Aktuatorarm ein erstes Ende und zweites Ende auf. Das erste Ende und das zweite Ende des Aktuatorarms bezeichnen bevorzugt Endbereiche des Aktuatorarms. Insbesondere können das erste und das zweite Ende Verbindungsabschnitte des Aktuatorarms bilden. Vorzugsweise ist der Aktuatorarm an dem ersten Ende mit der Rahmenstruktur verbunden und mit dem zweiten Ende mit dem Aktuatorkörper verbunden.

Dabei weist der Aktuatorarm bevorzugt eine Mäanderstruktur umfassend zwei oder mehr Aktuatorabschnitte auf.

Eine Mäanderstruktur bezeichnet bevorzugt eine aus einer Abfolge zueinander im Wesentlichen orthogonaler Abschnitte im Querschnitt gebildeten Struktur. Bei den zueinander orthogonalen Abschnitten handelt es sich bevorzugt um vertikale und horizontale Abschnitte, wobei bevorzugt die vertikalen Abschnitte durch die Aktuatorabschnitte gebildet werden. Besonders bevorzugt ist die Mäanderstruktur im Querschnitt rechteckig. Es kann aber auch bevorzugt sein, dass die Mäanderstruktur im Querschnitt eine Sägezahnform (Zick-Zack-Form) aufweist oder kurvenförmig bzw. wellenförmig ausgestaltet ist. Dies ist insbesondere der Fall, sofern die Aktuatorabschnitte nicht exakt parallel zueinander ausgerichtet sind, sondern einen Winkel beispielsweise von ca. ± 30°, bevorzugt ca. ±20°, besonders bevorzugt ca. ± 10° mit einer vertikalen Richtung einschließen.

Horizontale Abschnitte bezeichnen bevorzugt Strukturen, durch die die Aktuatorabschnitte, d. h. die vertikalen Abschnitte der Mäanderstruktur, miteinander verbunden sind. In bevorzugten Ausführungsformen liegen die horizontalen Abschnitte unter einem orthogonalen Winkel von ca. 90° in vertikaler Richtung mit den Aktuatorabschnitten verbunden vor. Die horizontalen Abschnitte können in weiteren bevorzugten Ausführungsformen ebenfalls auch nicht exakt unter einem orthogonalen Winkel von ca. 90° zur vertikalen Richtung stehen, sondern beispielsweise einen Winkel zwischen ca. 60° und ca. 120°, bevorzugt zwischen ca. 70° und ca. 110°, besonders bevorzugt zwischen ca. 80° und ca. 100° mit der vertikalen Richtung einschließen.

Im Falle einer kurvenförmigen bzw. welligen Form der Aktuatorabschnitte und/oder horizontalen Abschnitte des Aktuatorarms im Querschnitt bezieht sich die Ausrichtung bevorzugt auf eine Tangente an die Aktuatorabschnitte und/oder horizontalen Abschnitte an deren jeweiligen Mittelpunkten.

Die Mäanderstruktur entspricht somit bevorzugt einer entlang der Breite gefalteten Membran. Im Sinne der Erfindung kann der Aktuatorarm daher bevorzugt auch als Faltenbalg bezeichnet werden. Die parallelen Falten des Faltenbalges bilden bevorzugt die vertikalen Abschnitte bzw. Aktuatorabschnitte. Die Verbindungsabschnitte zwischen den Falten bilden bevorzugt die horizontalen Abschnitte. Bevorzugt sind die Aktuatorabschnitte, die im Wesentlichen vertikal ausgerichtet sind, länger als die horizontalen Abschnitte, beispielsweise um einen Faktor 1,5, 2, 3, 4 oder mehr.

Die Aktuatorabschnitte bezeichnen bevorzugt Strukturen des Aktuatorarms bzw. der Mäanderstruktur des Aktuatorarms, die im Wesentlichen in einer vertikalen Ausrichtung angeordnet sind. In einer bevorzugten Ausführungsform sind die Aktuatorabschnitte im Wesentlichen parallel zur vertikalen Richtung ausgerichtet, wobei im Wesentlichen parallel einen Toleranzbereich von ca. ± 30°, bevorzugt ca. ± 20°, besonders bevorzugt ca. ± 10° um die vertikale Richtung meint. Die Aktuatorabschnitte können bevorzugt auch als vertikale Abschnitte der Mäanderstruktur bezeichnet werden.

Die Richtungsangaben vertikal und horizontal (bzw. lateral) beziehen sich bevorzugt auf eine Vorzugsrichtung, in welcher der Aktuatorarm zur Auslenkung und/oder Bewegung des Aktuatorkörpers ausgerichtet ist. Bevorzugt ist der Aktuatorarm horizontal an mindestens einem Seitenbereich der Rahmenstruktur aufgehangen, während die vertikale Richtung im Wesentlichen orthogonal dazu vorliegt.

Die Aktuatorabschnitte des Aktuatorarms bzw. der Mäanderstruktur des Aktuatorarms bezeichnen somit bevorzugt Abschnitte, welche im Wesentlichen orthogonal zur horizontalen Aufhängrichtung des Aktuatorarms ausgerichtet sind. Der Fachmann versteht, dass es sich nicht um eine exakte vertikale Ausrichtung handeln muss, sondern bevorzugt um eine im Wesentlichen vertikale Ausrichtung.

Der Aktuatorarm mit Mäanderstruktur umfasst zwei oder mehr oder mehr Aktuatorabschnitte, wobei die zwei oder mehr Aktuatorabschnitte im Wesentlichen senkrecht zu einer Längsachse des Aktuatorarms ausgerichtet sind. Im Wesentlichen senkrecht zu einer Längsachse des Aktuatorarms bezieht sich bevorzugt auf eine orthogonale Richtung in Bezug auf die Aufhängrichtung des Aktuatorarms. So ist bevorzugt der Aktuatorarm entlang seiner Längsachse bevorzugt mindestens mit seinem ersten Ende mit der Rahmenstruktur verbunden. Die horizontale Richtung entspricht bevorzugt im Wesentlichen den Richtungen der Längsachse des Aktuatorarms.

Bevorzugt ist durch eine Ansteuerung der zwei oder mehr Aktuatorabschnitte eine Bewegung und/oder Auslenkung des Aktuatorkörpers bewirkbar. Eine Ansteuerung der zwei oder mehr Aktuatorabschnitte bezeichnet bevorzugt eine Wirkübertragung auf die zwei oder mehr Aktuatorabschnitte, sodass eine Bewegung und/oder eine Auslenkung des Aktuatorkörpers durch die Ansteuerung resultiert. Die Wirkübertragung auf die zwei oder mehr Aktuatorabschnitte kann bevorzugt durch ein Steuersignal erfolgen, beispielsweise in Form eines elektrischen Signals.

Dazu ist es bevorzugt, dass die zwei oder mehr Aktuatorabschnitte mindestens ein Aktuatormaterial aufweisen. Durch das Aktuatormaterial wird die Ansteuerung in eine Bewegung und/oder Auslenkung des Aktuatorkörpers übersetzt. Beispielsweise kann es sich bei dem Aktuatormaterial um ein piezoelektrisches oder thermosensitives Material handeln. Ohne an eine Theorie gebunden sein zu wollen, werden die Wirkprinzipien durch den Einsatz dieser Materialien als Aktuatormaterial im weiteren Verlauf näher beschrieben.

Bevorzugt dient das Aktuatormaterial in den Aktuatorabschnitten als Bestandteil eines mechanischen Bimorphs, wobei durch Ansteuerung der Aktuatorlage bevorzugt eine Auslenkung und/oder laterale Wölbung der Aktuatorabschnitte bewirkt wird. So können die Aktuatorabschnitte bevorzugt mindestens zwei Lagen umfassen, wobei eine erste Lage ein Aktuatormaterial und eine zweite Lage ein mechanisches Stützmaterial umfasst und/oder wobei beide Lagen ein Aktuatormaterial umfassen. Bei Ansteuerung kann das Aktuatormaterial beispielsweise eine transversale oder longitudinale Streckung oder Stauchung gegenüber einer mechanischen Stützschicht erfahren, wodurch ein Stressgradient erzeugt wird. Alternativ kann eine relative Formänderung zweier angesteuerter Aktuatorlagen erzeugt werden.

Der resultierende Stressgradient zwischen beiden Lagen eines Aktuatorabschnittes kann bevorzugt eine laterale Wölbung und/oder Auslenkung der Aktuatorabschnitte bewirken, die sich aufsummieren und somit zu hohen Auslenkungen des Aktuatorkörpers führen.

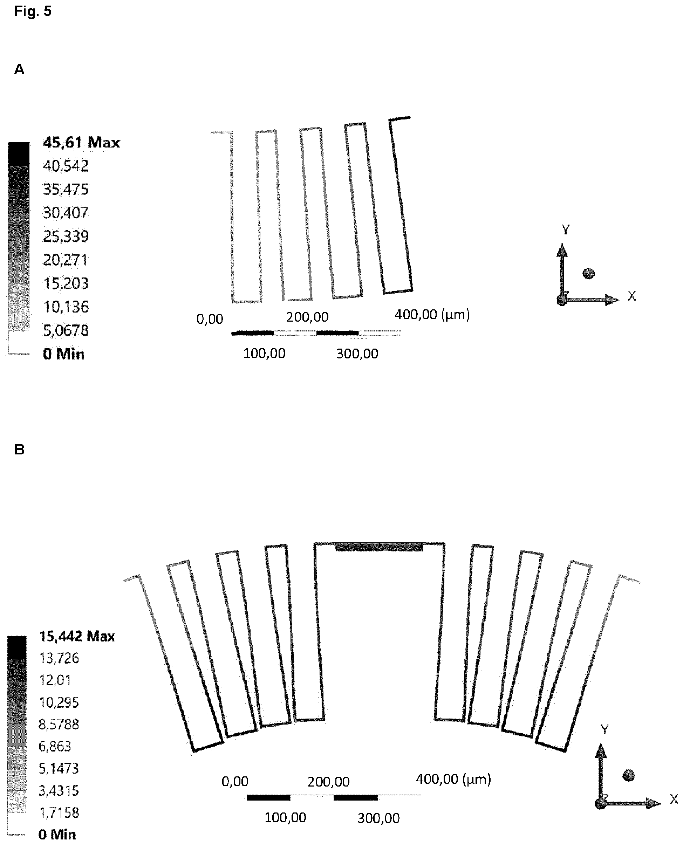

Insbesondere im Falle einer zweiseitigen Einspannung eines Aktuatorarmes kann eine laterale Wölbung der Aktuatorabschnitte auftreten. Eine laterale Wölbung der Aktuatorabschnitte tritt bevorzugt auf, sofern die Verbindungsstellen zwischen dem Aktuatorabschnitt und horizontalem Abschnitt in ihrer Bewegung eingeschränkt sind. Dies kann beispielsweise auftreten, wenn an einem Aktuatorkörper beidseitig zwei Aktuatorarme angebracht werden (vgl. Fig. 5B).

Sofern der Aktuatorkörperan einem Ende des Aktuatorarmes nicht fixiert, sondern frei ist (einseitige Einspannung des Aktuatorarms), wird durch die Ansteuerung derAktuatorabschnitte in der Regel keine laterale Wölbung bewirkt, stattdessen erfolgt eine Auslenkung der Aktuatorabschnitte, welche sich über die Länge des Aktuatorarmes zu einer gesamtheitlichen Auslenkung und/oder Verkippung des Aktuatorkörpers aufsummieren (vgl. Fig. 5A). Mit der Auslenkung im Falle eines einzelnen Aktuatorarms ist bevorzugt gemeint, dass es zu einer Veränderung des Winkels zwischen dem Aktuatorabschnitt (vertikalem Abschnitt) und dem horizontalen Abschnitt des Aktuatorarms kommt. Die gesamtheitliche Auslenkung des Aktuatorarms im Falle der Anbringung des Aktuatorkörpers über einen einzelnen Aktuatorarm am Träger resultiert ebenfalls vorzugsweise aus einem Stressgradienten zwischen zwei Lagen eines mechanischen Bimorphs. Aufgrund einer einseitigen Einspannung des Aktuatorarms, welche eine freiere Bewegung der Verbindungsstellen zwischen horizontalen Abschnitten und Aktuatorabschnitten erlaubt, erfahren die Aktuatorabschnitte jedoch keine wesentliche horizontale bzw. laterale Wölbung. Stattdessen erfolgt vorzugsweise eine Auslenkung derAktuatorabschnitte, bei der die Aktuatorabschnitte im Querschnitt einen im Wesentlichen geradlinigen Verlauf behalten (vgl. Fig. 5A). Die einzelnen Auslenkungen derAktuatorabschnitte summieren sich mit oder ohne Auftreten einer lateralen Wölbung über die Länge des Aktuatorarmes zu einer gesamtheitlichen Auslenkung auf.

Mithin kann durch die Ausgestaltung des Aktuatorarms, unabhängig von der Anzahl der Aktuatorarme, eine hohe Auslenkung oder Verkippung des Aktuatorkörpers erzielt werden.

Bevorzugt liegt die mindestens eine Aktuatorlage des Aktuatorarms als eine durchgängige Lage des Aktuatormaterials vor. Durchgängig meint bevorzugt, dass im Querschnittsprofil keine Unterbrechungen vorliegen. Demgemäß ist es in der genannten Ausführungsform bevorzugt, dass sowohl eine durchgängige Lage von einem Aktuatormaterial in den Aktuatorabschnitten als auch in den horizontalen Abschnitten vorliegt. Vorteilhaft ist mithin keine Strukturierung im Herstellungsverfahren notwendig. Eine durchgängige Lage ist besonders einfach in der Herstellung.

Der Aktuatorkörper bezeichnet bevorzugt die Komponente des MEMS-Aktuators, welche für den jeweiligen Verwendungszweck ausgelenkt und/oder bewegt werden soll. Bevorzugt ist der Aktuatorkörper eine Struktur, die größere Abmessungen als einen horizontalen Abschnitt aufweist. Besonders bevorzugt ist der Aktuatorkörper ein Stück eines Substrats, welches am zweiten Ende des Substrats verbunden ist. Mithilfe des bevorzugten MEMS-Aktuators kann der Aktuatorkörper über mehrere Bewegungsformen eine Auslenkung und/oder Bewegung erfahren.

In einer bevorzugten Ausführungsform ist der MEMS-Aktuator dadurch gekennzeichnet, dass die Bewegung des Aktuatorkörpers eine Translation, Rotation, Torsion und/oder Verkippung umfasst.

Vorteilhafterweise ist es mittels des erfindungsgemäßen Prinzips möglich, einen MEMS-Aktuator für vielfältige Bewegungsformen bereitzustellen.

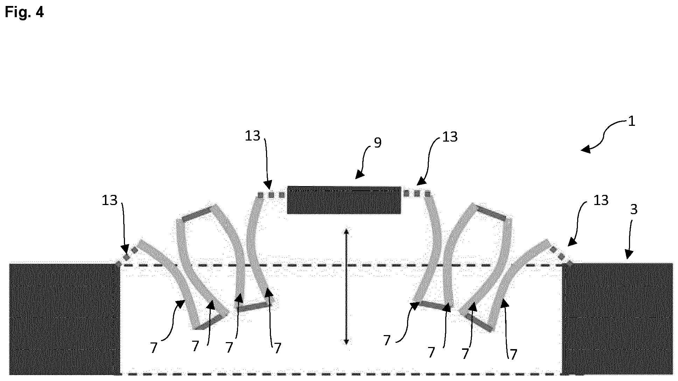

Eine Translation bezeichnet bevorzugt eine im Wesentlichen geradlinige Bewegung. So kann eine Translation eine Bewegung bevorzugt entlang einer oder mehrere Achsen oder entlang oder senkrecht einer Ebene betreffen. In bevorzugten Ausführungsformen handelt es sich bei der Translation um eine vertikale Translation, bei welcher der Aktuatorkörper orthogonal aus der Ebene des einen oder der mehreren Aktuatorarme bewegt wird. Hierzu können beispielsweise zwei Aktuatorarme gegenüberliegend an dem Aktuatorkörper angebracht vorliegen (vgl. Fig. 4).

Eine Rotation oder Verkippung bezeichnet bevorzugt eine Rotation des Aktuatorkörpers entlang einer Rotationsachse (auch Drehachse) oder eines Rotationspunktes (auch Drehpunkt). Bei der Rotation um eine Rotations- bzw. Drehachse bleiben Punkte der Rotationsachse an ihrem Ort, während andere Punkte des Aktuatorkörpers sich in festem Abstand von der Achse auf einem senkrecht zur Achse liegenden Kreis um denselben Winkel bzw. mit derselben Winkelgeschwindigkeit um sie herumbewegen.

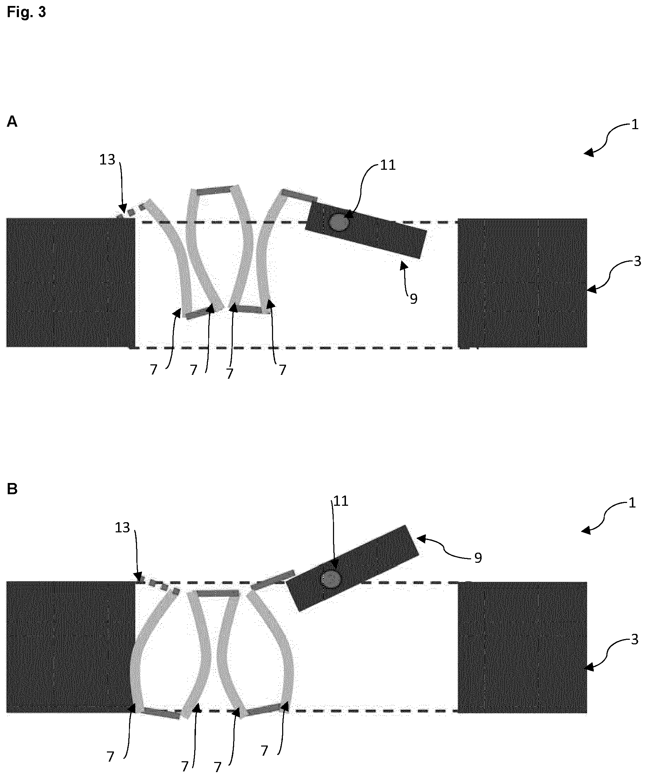

Ein Rotationspunkt bzw. Drehpunkt kann bevorzugt ein Punkt sein, an dem der Aktuatorkörper fixiert wird (durch entsprechende Maßnahmen, z. B. durch die Anbringung von Fixierungselementen) und um diesen Punkt eine Rotation bzw. Verkippung durchgeführt wird (vgl. Fig. 3).

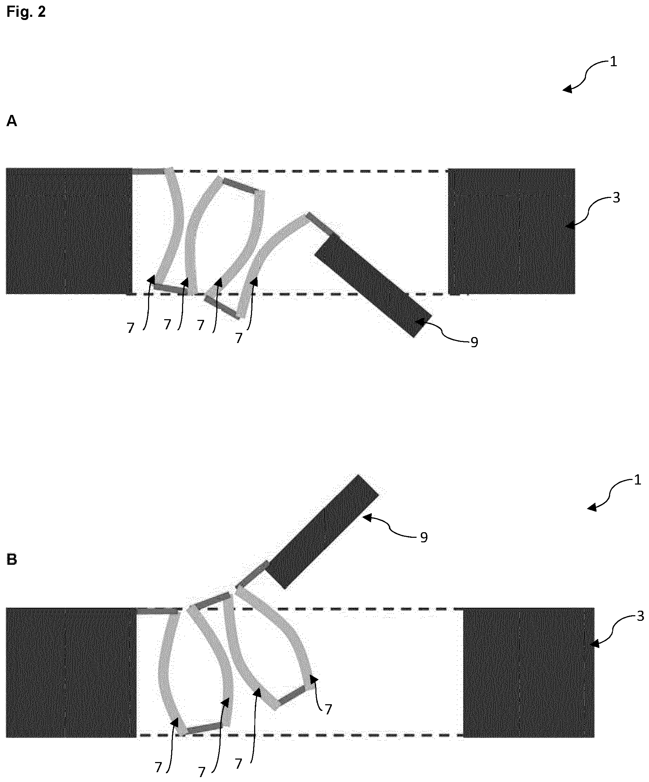

Ebenso kann eine Rotation bzw. Verkippung des Aktuators um eine nicht ortsfeste Drehachse vollzogen werden. Beispielsweise kann die Bewegung des Aktuatorkörpers eine Überlagerung einer Rotation und Translation umfassen. Dies kann z. B. der Fall sein, sofern der Aktuatorkörper nicht mit einem Fixierungsmittel verbunden vorliegt. Hierbei kann der Aktuatorkörper an einer Seite mit einem Aktuatorarm verbunden vorliegen, während der Aktuatorkörper ansonsten frei in der Bewegung ist. Durch eine Ansteuerung des einseitigen Aktuatorarms wird eine Rotation bzw. Verkippung des Aktuatorkörpers bewirkt, während sich dieser (und mithin die Drehachse) abwechselnd "nach unten" und "nach oben" bewegt (vgl. Fig. 2).

Eine Torsion bezeichnet bevorzugt eine Verdrehung des Aktuatorarms und/oder des Aktuatorkörpers, die durch die Wirkung eines Torsionsmoments entsteht. Dabei kann es bevorzugt sein, dass der Aktuatorkörper mit mehreren Aktuatorarmen verbunden vorliegt, welche ein entsprechendes Torsionsmoment bewirken.

In einer weiteren bevorzugten Ausführungsform ist der MEMS-Aktuator dadurch gekennzeichnet, dass die zwei oder mehr Aktuatorabschnitte durch Aufbringung mindestens einer Lage umfassend ein Aktuatormaterial auf eine Mäanderstruktur eines Substrates gebildet wurden, wobei bevorzugt Bereiche der Mäanderstruktur des Substrates zur Bildung der zwei oder mehr Aktuatorabschnitte orthogonal zur Oberfläche des Substrats orientiert waren.

Der MEMS-Aktuator umfassend einen Aktuatorarm mit einer Mäanderstruktur ist bevorzugt mittels eines Halbleiterprozesses aus einem Substrat formbar. Hierzu wird bevorzugt das Substrat geätzt, bevorzugt ausgehend von einer Vorderseite, um die Struktur, bevorzugt eine Mäanderstruktur, auszubilden. Weiterhin ist es bevorzugt, mindestens eine Lage umfassend ein Aktuatormaterial aufzubringen. Bevorzugt werden zwei Lagen aufgebracht, wobei die zwei Lagen eine Lage umfassend eine Aktuatormaterial und eine mechanische Stützschicht oder zwei Lagen umfassend ein Aktuatormaterial sein können. Durch die Aufbringung zweier Lagen wird bevorzugt der mechanische Bimorph gebildet, wobei ein Aktuatorabschnitt als mechanischer Bimorph aufzufassen ist und dieser durch die Ätzung vertikal zur Substratoberfläche angeordnet sind. Durch eine bevorzugte Ätzung, vorzugsweise ausgehend von einer Rückseite, erfolgt die Freistellung des Aktuatorarms.

Die Bereiche einer Mäanderstruktur, an welchen die Aktuatorabschnitte (vertikale Abschnitte) des Aktuatorarms gebildet werden, liegen damit bevorzugt im Wesentlichen vertikal zur Substratoberfläche vor, aus welcher die Rahmenstruktur und/oder der Aktuatorarm gebildet wurde. Im fertigen MEMS-Aktuator erstreckt sich der Aktuatorarm bevorzugt im Wesentlichen horizontal zur (ursprünglichen) Substratoberfläche (z. B. eines Wafers), während die Aktuatorabschnitte vertikal zur (ursprünglichen) Substratoberfläche angeordnet sind.

Bevorzugt ist die Rahmenstruktur und/oder der Aktuatorkörper aus demselben Substrat herstellbar. Mithin ist die ursprüngliche Orientierung der Bereiche des Substrats, durch welche die zwei oder mehr Aktuatorabschnitte bereitgestellt wurden, an der Rahmenstruktur und/oder dem Aktuatorkörper für einen durchschnittlichen Fachmann erkennbar.

In einer weiteren bevorzugten Ausführungsform ist der MEMS-Aktuator dadurch gekennzeichnet, dass die zwei oder mehr Aktuatorabschnitte mindestens zwei Lagen umfassen, wobei bevorzugt eine Lage ein Aktuatormaterial und eine zweite Lage ein mechanisches Stützmaterial umfasst und/oder wobei beide Lagen ein Aktuatormaterial umfassen.

Vorteilhafterweise kann durch die bevorzugte Anordnung umfassend zwei Lagen umfassend ein Aktuatormaterial oder eine Lage umfassend ein Aktuatormaterial und eine Lage umfassend ein mechanisches Stützmaterial eine hoch effiziente Übersetzung der Ansteuerung erfolgen, durch welche die Bewegung und/oder Auslenkung des Aktuatorkörpers bewirkbar ist.

In einer bevorzugten Ausführungsform umfassen die zwei oder mehr Aktuatorabschnitte eine Lage umfassend ein Aktuatormaterial und eine Lage umfassend ein mechanisches Stützmaterial.

Bevorzugt dient die Lage aus einem Aktuatormaterial in den Aktuatorabschnitten als Bestandteil eines mechanischen Bimorphs, wobei durch Ansteuerung des Aktuatormaterials, z. B. mithilfe einer Elektrode, die vorzugsweise endseitig kontaktiert vorliegt, eine Bewegung des Aktuatorkörpers resultiert.

Bei Ansteuerung der Lage umfassend ein Aktuatormaterial (auch als Aktuatorlage bezeichnet) kann dieses beispielsweise eine transversale oder longitudinale Streckung oder Stauchung erfahren. Gegenüber der mechanischen Stützschicht wird hierdurch ein Stressgradient erzeugt, welcher zu einer lateralen Wölbung oder Auslenkung der Aktuatorlage führt. Während die Aktuatorlage, z. B. durch Anlegen einer elektrischen Spannung, eine Formänderung erfährt, verbleibt die Lage des mechanischen Stützmaterials im Wesentlichen unverändert. Der resultierende Stressgradient zwischen beiden Lagen kann bevorzugt eine laterale Wölbung bzw. Auslenkung der Aktuatorabschnitte bewirken, die sich aufsummieren und somit zu hohen Auslenkungen des Aktuatorkörpers führen.

Für die Lage umfassend das mechanische Stützmaterial (auch Stützlage) ist die Dicke der Stützlage im Vergleich zur Dicke der Aktuatorlage bevorzugt so zu wählen, dass ein hinreichend großer Stressgradient generiert wird, welche eine laterale Wölbung und/oder Auslenkung bewirkt. Für dotiertes Polysilizium als mechanisches Stützmaterial und einem piezoelektrischen Material wie PZT oder AIN als Aktuatormaterial haben sich beispielsweise im Wesentlichen gleich große Dicken, bevorzugt zwischen ca. 0,5 µm und ca. 2 µm, als besonders geeignet erwiesen.

Im Sinne der Erfindung wird die Lage umfassend ein mechanisches Stützmaterial bevorzugt auch als Stützlage oder Stützschicht bezeichnet. Das mechanische Stützmaterial bzw. die Stützlage dient bevorzugt als passive Lage, welche einer Formänderung der Aktuatorlage (Lage umfassend Aktuatormaterial) widerstehen kann. Im Gegensatz zu einer Aktuatorlage ändert das mechanische Stützmaterial durch die Ansteuerung, beispielsweise beim Anlegen einer elektrischen Spannung, bevorzugt seine Form nicht. Bevorzugt ist das mechanische Stützmaterial elektrisch leitend, sodass es auch unmittelbar für eine Kontaktierung der Aktuatorlage verwandt werden kann. Es kann aber auch in einigen Ausführungsformen nichtleitend sein und beispielsweise mit einer elektrisch leitfähigen Lage beschichtet vorliegen.

Bevorzugt ist das mechanische Stützmaterial ausgewählt aus einer Gruppe umfassend monokristallines Silizium (Monosilizium), polykristallines Silizium (Polysilizium) und/oder ein dotiertes Polysilizium.

In einer bevorzugten Ausführungsform umfassen die zwei oder mehr Aktuatorabschnitte mindestens zwei Lagen umfassend ein Aktuatormaterial. In dieser Ausführungsform wird die Bewegung des Aktuatorkörpers mithin nicht durch einen Stressgradienten zwischen einer aktiven Aktuatorlage und einer passiven Stützschicht generiert, sondern durch eine relative Formänderung zweier aktiver Aktuatorlagen. Die Aktuatorlagen können hierbei aus demselben Aktuatormaterial bestehen. Auch können die Aktuatorlagen aus unterschiedlichen Aktuatormaterialien bestehen, beispielsweise aus piezoelektrischen Materialien mit unterschiedlichen Deformationskoeffizienten.

Im Sinne der Erfindung wird die Lage umfassend ein Aktuatormaterial bevorzugt auch als Aktuatorlage bezeichnet. Ein Aktuatormaterial meint bevorzugt ein Material, welches über eine Ansteuerung durch ein Steuersignal, beispielsweise unter Anlegung einer elektrischen Spannung, eine Formänderung erfährt und/oder umgekehrt unter Formänderung eine elektrische Spannung erzeugt. Die Formänderung kann beispielsweise durch eine Dehnung, Stauchung oder Scherung erfolgen.

Bevorzugt sind Materialien mit elektrischen Dipolen als Aktuatormaterial gewählt, welche durch das Anlegen einer elektrischen Spannung eine Formänderung erfahren, wobei die Orientierung der Dipole und/oder des elektrischen Feldes die Vorzugsrichtung der Formänderungen bestimmen kann.

In einer weiteren bevorzugten Ausführungsform ist der MEMS-Aktuator dadurch gekennzeichnet, dass das Aktuatormaterial ein piezoelektrisches Material, ein Polymer Piezoelectrical Material, elektroaktive Polymere (EAP) und/oder ein thermosensitives Material umfasst.

Die genannten Materialien haben sich als besonders vorteilhaft erwiesen, um als Aktuatormaterial im Kontext des bevorzugten MEMS-Aktuators eingesetzt zu werden. So übersetzen sie besonders gut die bevorzugte Ansteuerung durch ein Steuersignal in Bewegungen und/oder Auslenkungen des Aktuatorkörpers.

Besonders bevorzugt ist das piezoelektrische Material ausgewählt aus einer Gruppe umfassend Blei-Zirkonat-Titanat (PZT), Aluminiumnitrid (AIN), Aluminium-Scandium-Nitrid (AIScN) und/oder Zinkoxid (ZnO).

Zu den Polymer Piezoelectric Materialien (auch als piezoelektrisches Polymermaterial bekannt) gehören bevorzugt Polymere, welche interne Dipole und hierdurch vermittelte piezoelektrische Eigenschaften aufweisen. D. h. bei Anlegen einer äußeren elektrischen Spannung erfahren die Polymer Piezoelectric Materialien (analog zu den vorgenannten klassischen piezoelektrischen Materialien) eine Formänderung (z. B. eine Stauchung, Streckung oder Scherung). Ein Beispiel für ein bevorzugtes piezoelektrisches Polymermaterial ist Polyvinylidenfluorid (PVDF).

Thermosensitive Materialien bezeichnen bevorzugt Materialien, die mithilfe einer hinreichenden Verformung durch einen thermischen Effekt eine Bewegung des Aktuatorkörpers bewirken. Beispielsweise können thermosensitive Materialien ein Bimetall aufweisen und damit einen Bimetall-Effekt nutzen. Ein Bimetall umfasst eine Sandwichstruktur umfassend zwei unterschiedlichen Schichten (Bimorph), die unterschiedliche Wärmeausdehnungskoeffizienten aufweisen und sich durch ein Heizelement erwärmen und daraufhin und verformen lassen. Als bevorzugte thermosensitive Materialien können beispielsweise Silizium, Siliziumdioxid und/oder Gold eingesetzt werden, insbesondere im Falle eines Bimetalls Materialkombinationen aus Silizium und Gold und/oder Silizium und Siliziumdioxid.

In einer weiteren bevorzugten Ausführungsform ist der MEMS-Aktuator dadurch gekennzeichnet, dass der Aktuatorarm mit mindestens einer Elektrode kontaktiert vorliegt und vorzugsweise eine Ansteuerung der Aktuatorabschnitte durch ein elektrisches Steuersignal erfolgt.

Bevorzugt ist eine Positionierung der mindestens eine Elektrode endseitig vorgesehen, sodass eine Kontaktierung mit einer Elektronik, z. B. an einer Strom- oder Spannungsquelle an einem Ende des Aktuatorarms erfolgen kann, bevorzugt an einem Ende, an welchem der Aktuatorarm an der Rahmstruktur aufgehangen vorliegt. Elektrode meint bevorzugt einen Bereich aus einem leitfähigen Material (bevorzugt einem Metall), welcher für eine solche Kontaktierung mit einer Elektronik, z. B. einer Strom- und/oder Spannungsquelle eingerichtet ist. Bevorzugt kann es sich um ein Elektrodenpad handeln. Besonders bevorzugt dient das Elektrodenpad der Kontaktierung mit einer Elektronik und ist selbst mit einer leitfähigen Metallschicht verbunden, welche sich über die gesamte Fläche des Aktuatorarms erstrecken kann.

Hierzu kann es bevorzugt sein, eine Lage umfassend ein elektrisch leitfähiges Material auf die Aktuatorlage und/oder die Stützlage aufzubringen. Die Lage umfassend das elektrisch leitfähige Material kann bevorzugt auf einer Vorderseite und/oder bevorzugt auf einer Rückseite des Aktuatorsmaterials aufgebracht werden. Eine Lage umfassend ein elektrisch leitfähiges Material auf einer Vorderseite wird bevorzugt als Top-Elektrode bezeichnet. Analog wird eine Lage umfassend ein elektrisch leitfähiges Material auf einer Rückseite bevorzugt als Bottom-Elektrode bezeichnet. Teilweise wird im Folgenden die leitfähige Schicht zusammen mit einem Elektrodenpad als Elektrode, beispielsweise als Top-Elektrode oder Bottom-Elektrode bezeichnet.

Besonders bevorzugt liegt eine Lage aus einem leitfähigen Material, bevorzugt einem Metall, im Sinne einer Top- oder Bottom-Elektrode als eine durchgängige bzw. ganzflächige oder zusammenhängende Schicht der schwingfähigen Membran vor, welche eine im Wesentlichen homogene Fläche bildet und insbesondere nicht strukturiert wird. Stattdessen werden bevorzugt mittels einer unstrukturierten Lage aus einem leitfähigem Material, bevorzugt Metall, die zwei oder mehr Aktuatorabschnitte mit einer oder zwei endseitigen Elektroden kontaktiert.

In bevorzugten Ausführungsformen umfasst der MEMS-Aktuator zwei endseitige Elektroden. Bevorzugt kann die Kontaktierung mit einer Elektronik, z. B. einer Strom- und/oder Spannungsquelle, mit den Elektroden an dem Ende des Aktuatorarms erfolgen, an welchem dieser an der Rahmenstruktur aufgehangen vorliegt.

Das elektrische Steuersignal wird bevorzugt durch eine Elektronik, beispielsweise durch eine Strom- und/oder Spannungsquelle erzeugt, durch welche Auslenkungen und/oder laterale Wölbungen der Aktuatorabschnitte verursacht werden.

In einer weiteren bevorzugten Ausführungsform ist der MEMS-Aktuator dadurch gekennzeichnet, dass der MEMS-Aktuator ein Fixierungselement aufweist, welches mit dem Aktuatorkörper verbunden ist, sodass durch die Anlegung des Steuersignals der Aktuatorkörper entlang eines Drehpunktes und/oder einer Drehachse verkippbar ist.

Vorteilhaft kann mithilfe eines Fixierungselements sowohl die Richtung als auch die Auslenkung des Aktuatorkörpers vorgegeben werden, sodass eine Auslenkung auf gewünschte Weise in Form einer Verkippung ausgeführt werden kann.

Ein Fixierungselement bezeichnet bevorzugt eine Komponente des MEMS-Aktuators, an dem der Aktuatorkörper entlang einer Achse und/oder an einem Punkt fixierbar ist. Mithin kann der Aktuatorkörper entlang dieser Achse (Drehachse) und/oder des Punktes (Drehpunktes) eine Rotation und/oder Verkippung ausführen. Das Fixierungselement für eine Rotation und/oder Verkippung entlang einer Drehachse kann beispielsweise dadurch bereitgestellt werden, dass während der Herstellung ein Stück vom Substrat belassen wird und mit dem Aktuatorkörper verbunden ist.

Das Fixierungselement für eine Rotation und/oder Verkippung entlang eines Drehpunktes kann z. B. auch durch die Anbringung einer MEMS-Torsionsfeder erfolgen. Die MEMS-Torsionsfeder ermöglicht vorzugsweise, dass der Aktuatorkörper in einer bestimmten Drehrichtung gedreht und die Drehung des Aktuatorkörpers in andere Richtungen begrenzt werden kann.

Ebenso kann das Fixierungselement für eine Rotation und/oder Verkippung entlang eines Drehpunktes auch durch ein Mikrogelenk bereitgestellt werden.

In einer weiteren bevorzugten Ausführungsform ist der MEMS-Aktuator dadurch gekennzeichnet, dass das erste Ende des Aktuatorarms über ein mechanisch starres oder flexibles Verbindungsstück mit der Rahmenstruktur verbunden vorliegt.

Mit einem Verbindungsstück ist bevorzugt eine Komponente gemeint, die als Zwischenkomponente zwischen dem Aktuatorarm und der Rahmenstruktur vorliegt. Bevorzugt ist das Verbindungsstück an dem ersten Ende des Aktuatorarms angebracht, sodass das Verbindungsstück bevorzugt auch als Teil des Aktuatorarms aufgefasst werden kann.

Vorteilhaft resultiert durch die Platzierung eines Verbindungsstückes zwischen dem Aktuatorarm und der Rahmenstruktur eine besonders zuverlässige Verbindung. Weiterhin begünstigt das Verbindungsstück die Beweglichkeit des Aktuatorkörpers.

Im Falle eines mechanisch flexiblen Verbindungsstückes liegt vorteilhaft ein verminderter mechanischer Widerstand an dem ersten Ende und damit an der Verbindungsstelle des Aktuatorarms mit der Rahmenstruktur vor, sodass die Bewegung des Aktuatorkörpers mit besonders geringem mechanischen Widerstand erfolgt. Ein mechanisch flexibles Verbindungsstück zeichnet sich neben einer Flexibilität bevorzugt durch elastische Eigenschaften aus, um eine Rückstellkraft auf eine Vorzugsposition zu gewährleisten. Bevorzugt kann es sich bei einem mechanisch flexiblen Verbindungsstück um eine MEMS-Feder handeln. Die MEMS-Feder als mechanisch flexibles Verbindungsstück kann beispielsweise als doppelt gefalteter Balken (englisch: double folded beam) ausgebildet sein, eine U-Form aufweisen (englisch: U-shaped) oder in Form einer fish-hook-Feder vorliegen.

Ein mechanisch starres Verbindungsstück bezeichnet vorzugsweise ein Verbindungsstück, welches durch eine Bewegung des Aktuatorkörpers im Wesentlichen nicht bewegbar und/oder nicht verformbar ist. Ein mechanisch starres Verbindungsstück hat sich als eine besonders stabile und robuste Verbindung zwischen Aktuatorarm und Rahmenstruktur herausgestellt und eignet sich für jene Anwendungszwecke, bei denen ein hoher mechanischer Widerstand am ersten Ende des Aktuatorarms erwünscht ist. Das mechanisch starre Verbindungsstück kann bevorzugt während der Herstellung des MEMS-Aktuators als Teil des Substrats bzw. der Rahmenstruktur angebracht sein.

In einer weiteren bevorzugten Ausführungsform ist der MEMS-Aktuator dadurch gekennzeichnet, dass durch Ansteuerung der zwei oder mehr Aktuatorabschnitte der Aktuatorkörper um mindestens ca. 10°, bevorzugt um mindestens ca. 20°, besonders bevorzugt um mindestens ca. 40°, ganz besonders bevorzugt um mindestens ca. 60° verkippbar ist. Die vorgenannten möglichen Kippwinkel bezeichnet bevorzugt Winkel in einer Drehrichtung, um welche der Aktuatorkörper verkippt bzw. rotiert werden kann. Eine abwechselnde Kippbewegung des Aktuatorkörpers kann vorzugsweise mit Kippwinkel von mindestens ca. ± 10°, ± 20°, ± 40°, ± 60° oder mehr erfolgen.

Vorteilhafterweise können mittels des bevorzugten MEMS-Aktuators, insbesondere durch die Mäanderstruktur des Aktuatorarms umfassend die zwei oder mehr Aktuatorabschnitte, besonders hohe Auslenkungen bzw. Verkippungen des Aktuatorkörpers erreicht werden. Weiterhin ist es von Vorteil, dass mögliche Freiheitsgrade, beispielsweise hinsichtlich einer Verkippung, angepasst werden können, beispielsweise durch die Anbringung einer oder mehrerer Fixierungselemente und/oder weiterer Aktuatorarme.

In einer weiteren bevorzugten Ausführungsform ist der MEMS-Aktuator dadurch gekennzeichnet, dass der Aktuatorarm eine Länge zwischen 10 µm und 10 mm, bevorzugt zwischen 50 µm und 1000 µm aufweist. Auch Zwischenbereiche aus den vorgenannten Bereichen können bevorzugt sein, wie beispielsweise 10 µm bis 100 µm, 100 µm bis 200 µm, 200 µm bis 300 µm, 300 µm bis 400 µm, 400 µm bis 500 µm, 500 µm bis 1000 µm, 1 mm bis 2 mm, 3 mm bis 4 mm, 4 mm bis 5 mm, 5 mm bis 8 mm oder auch 8 mm bis 10 mm. Ein Fachmann erkennt, dass die vorgenannten Bereichsgrenzen auch kombiniert werden können, um weitere bevorzugte Bereich zu erhalten, wie beispielsweise 10 µm bis 500 µm, 500 µm bis 1 mm oder auch 1 mm bis 5 mm.

In einer weiteren bevorzugten Ausführungsform ist der MEMS-Aktuator dadurch gekennzeichnet, dass die Aktuatorabschnitte eine Höhe zwischen ca. 1 µm und ca. 1000 µm, bevorzugt zwischen ca. 10 µm und ca. 500 µm, und/oder eine Dicke zwischen ca. 100 nm und ca. 10 µm, bevorzugt zwischen ca. 500 nm und ca. 5 µm aufweisen.

In einer bevorzugten Ausführungsform beträgt die Höhe der Aktuatorabschnitte zwischen 1 µm und 1000 µm, bevorzugt zwischen 10 µm und 500 µm. Auch Zwischenbereiche aus den vorgenannten Bereichen können bevorzugt sein, wie beispielsweise 1 µm bis 10 µm, 10 µm bis 50 µm, 50 µm bis 100 µm, 100 µm bis 200 µm, 200 µm bis 300 µm, 300 µm bis 400 µm, 400 µm bis 500 µm, 600 µm bis 700 µm, 700 µm bis 800 µm, 800 µm bis 900 µm oder auch 900 µm bis 1000 µm. Ein Fachmann erkennt, dass die vorgenannten Bereichsgrenzen auch kombiniert werden können, um weitere bevorzugte Bereich zu erhalten, wie beispielsweise 10 µm bis 200 µm, 50 µm bis 300 µm oder auch 100 µm bis 600 µm.

In einer bevorzugten Ausführungsform beträgt die Dicke der Aktuatorabschnitte zwischen 100 nm und 10 µm, bevorzugt zwischen 500 nm und 5 µm. Auch Zwischenbereiche aus den vorgenannten Bereichen können bevorzugt sein, wie beispielsweise 100 nm bis 500 nm, 500 nm bis 1 µm, 1 µm bis 1,5 µm, 1,5 µm bis 2 µm, 2 µm bis 3 µm, 3 µm bis 4 µm, 4 µm bis 5 µm, 5 µm bis 6 µm, 6 µm bis 7 µm, 7 µm bis 8 µm, 8 µm bis 9 µm oder auch 9 µm bis 10 µm. Ein Fachmann erkennt, dass die vorgenannten Bereichsgrenzen auch kombiniert werden können, um weitere bevorzugte Bereich zu erhalten, wie beispielsweise 500 nm bis 3 µm, 1 µm bis 5 µm oder auch 1500 nm bis 6 µm.

Die genannten Zahlenwerte hinsichtlich der Länge des Aktuatorarmes oder der Formgebung der Aktuatorabschnitte haben sich dahingehend als vorteilhaft erwiesen, dass diese eine besonders effektive Bewegung des Aktuatorkörpers über große Winkelbereich erlauben.

Vorzugsweise korrespondiert die Länge des Aktuatorarms zudem mit der Anzahl und Ausgestaltung der Aktuatorabschnitte. Je mehr Aktuatorabschnitte vorliegen und desto länger die horizontalen Abschnitte zwischen den Aktuatorabschnitte ausgestaltet sind, umso länger ist der resultierende Aktuatorarm. Der durchschnittliche Fachmann ist in der Lage, je nach Anwendungsfall die entsprechenden Größen zu wählen, um die Eigenschaften des MEMS-Aktuators in Bezug auf eine Auslenkbarkeit und/oder Verkippbarkeit zu erhalten.

In einer weiteren bevorzugten Ausführungsform ist der MEMS-Aktuator dadurch gekennzeichnet, dass der mindestens eine Aktuatorarm mehr als 3, 4, 5, 10, 15, 20, 30, 40, 50, 100 oder mehr Aktuatorabschnitte umfasst.

Wie bereits dargelegt, korrespondiert die Anzahl der Aktuatorabschnitte mit der Länge des Aktuatorarms, dem aufzubringenden Steuersignal und/oder der Auslenkung als solche. Umso mehr Aktuatorabschnitte bereitgestellt werden, umso länger wird der Aktuatorarm bzw. desto höher ist die Auslenkung bzw. Verkippung, welche durch den Aktuator erreicht werden kann, da insbesondere mehr Aktuatorabschnitte in der Summe einen größeren Hub und/oder Moment erzeugen. Die Anzahl der Aktuatorabschnitte ist für einen Fachmann während eines bevorzugten Verfahrens zur Herstellung des bevorzugten MEMS-Aktuators einfach ein- bzw. bereitzustellen.

In einer weiteren bevorzugten Ausführungsform ist der MEMS-Aktuator dadurch gekennzeichnet, dass der Aktuatorkörper über ein, zwei, drei oder vier Aktuatorarmen mit der Rahmenstruktur verbunden vorliegt, wobei die ein, zwei, drei oder vier Aktuatorarme vorzugsweise in einer Ebene vorliegen.

Mit der Anzahl an Aktuatorarmen kann vorteilhaft die Auslenkung als solche und/oder die Zahl an Freiheitsgraden des Aktuatorkörpers auf einfache Weise und je nach Anwendungszweck optimiert werden. Weiterhin ermöglicht eine höhere Zahl an Aktuatorarmen vorteilhaft eine besonders sichere Verbindung zum Aktuatorkörper, da selbst bei einer Funktionsuntauglichkeit eines Aktuatorarms eine Verbindung mit der Rahmenstruktur gegeben ist. Des Weiteren kann durch eine höhere Anzahl an Aktuatorarmen die Auslenkung und/oder die Ansteuerung des Aktuatorkörpers effektiver ausgestaltet werden, da eine Ansteuerung von mehreren Seiten über mehrere Aktuatorarme erfolgt.

Weiterhin ist es bevorzugt, dass am jeweiligen ersten Ende der Aktuatorarme eine Elektrode kontaktiert vorliegt, um die Ansteuerung durch ein elektrisches Steuersignal zu ermöglichen. So liegen in bevorzugten Ausführungsformen zwei, drei, vier oder mehr endseitige Elektroden, d. h. insbesondere Elektroden kontaktiert mit dem jeweiligen ersten Ende der zwei, drei, vier oder mehr Aktuatorarme vor. Bevorzugt kann die Kontaktierung mit einer Elektronik, z. B. einer Strom- und oder Spannungsquelle, mit den Elektroden an gegenüberliegende Enden erfolgen, zwischen welchen die Aktuatorarme vorliegen, sodass mittels der endseitigen Elektroden die Aktuatorlage(n) in den Aktuatorabschnitten angesteuert werden können. Vorteilhaft ist es nicht notwendig, die einzelnen Aktuatorabschnitte der jeweiligen Aktuatorarme separat zu aktuieren, stattdessen kann eine vorteilhafte Aktuierung des Aktuatorkörpers durch eine endseitige elektronische Kontaktierung, z. B. mithilfe einer Elektrode, bevorzugt in Form eines Elektrodenpads, erfolgen.

Mittels eines Aktuatorarms kann vorzugsweise eine Verkippung bzw. Rotation um eine feststehende Drehachse oder einen feststehenden Drehpunkt ermöglicht werden.

Hingegen resultieren beispielsweise bei einer Anbringung von vier Aktuatorarmen, die im Wesentlichen einen Winkel von 90° zueinander aufweisen, höhere Freiheitsgrade hinsichtlich der Bewegbarkeit des Aktuatorkörpers. So kann z. B. durch die Ansteuerung zwei gegenüberliegender Aktuatorarme eine Bewegung oder Auslenkung des Aktuatorkörpers aus der Ebene heraus erfolgen. Durch die Ansteuerung einer der beiden anderen Aktuatorarme, die nicht für die Bewegung oder Auslenkung aus der Ebene heraus verantwortlich sind, kann eine Verkippung des Aktuatorkörpers überlagert werden. Ebenfalls kann bei der Anbringung vierer Aktuatorarme eine Schwenkung des Aktuatorkörpers in Richtungen erfolgen, die eine senkrechte Komponente zur Ebene besitzen. Mithin können vielfältige Bewegungsformen und Auslenkungsoptionen für den Aktuatorkörper geschaffen werden.

In einer weiteren bevorzugten Ausführungsform ist der MEMS-Aktuator dadurch gekennzeichnet, dass der Aktuatorkörper über zwei Aktuatorarme mit der Rahmenstruktur verbunden vorliegt, wobei die zwei Aktuatorarme in einer Ebene vorliegen und in der Ebene einen Winkel von im Wesentlichen 90° oder einen Winkel von im Wesentlichen 180° einschließen.

Eine bevorzugte Anbringung zweier Aktuatorarme von im Wesentlichen 180° zueinander zeichnet sich durch eine im Wesentlichen horizontale Erstreckung der Aktuatorarme aus, wobei bevorzugt mittig der Aktuatorkörper vorliegt. Bevorzugt erfolgt die Ansteuerung mithilfe eines elektrischen Steuersignals in gegensätzlicher Phase, sodass entgegengesetzte laterale Wölbungen der Aktuatorabschnitte der beiden Aktuatorarme erzeugt werden und beispielsweise eine Bewegung und/oder Auslenkung des Aktuatorkörpers aus der Ebene heraus ermöglicht wird. Eine solche vertikale Bewegbarkeit des Aktuatorkörpers aus der Ebene wird beispielsweise in der Fig. 4 illustriert.

Bei einer bevorzugten Anbringung zweier Aktuatorarme mit einem eingeschlossenen Winkel zwischen ca. 45° und ca. 135°, bevorzugt von im Wesentlichen 90°, liegt eine im Wesentlichen orthogonale Erstreckung der Aktuatorarme zueinander vor. Durch einen ersten Aktuatorarm kann hierbei vorzugsweise eine Rotation bzw. Verkippung um eine erste Rotationsachse und um den zweiten Aktuatorarm eine Rotation bzw. Verkippung um eine zweite Rotationsachse bewirkt werden. Auf diese Weise kann ein MEMS-Aktuator bereitgestellt werden, welcher eine 2D-Verkippung des Aktuatorkörpers präzise und über einen großen Winkelbereich ermöglicht. Ein auf diese Weise bereitstellbarer Mikrospiegel lässt sich vorteilhaft um zwei Achsen verkippen bzw. schwenken und beispielsweise einen Laserstrahl gezielt und präzise zu lenken.

In einer weiteren bevorzugten Ausführungsform ist der MEMS-Aktuator dadurch gekennzeichnet, dass der Aktuatorkörper mindestens abschnittsweise eine reflektive Oberfläche aufweist, besonders bevorzugt als einen Mikrospiegel ausgebildet ist.

Der bevorzugte MEMS-Aktuator hat sich insbesondere im Kontext von Mikrospiegeln als besonders vorteilhaft erwiesen. So können vorteilhaft große Auslenkungen, insbesondere in Form von großen Winkeln in Bezug auf eine Verkippung erreicht werden. Vorteilhaft kann insbesondere durch die Mäanderstruktur des Aktuatorarms umfassend den zwei oder mehr Aktuatorabschnitte besonders hohe Kippwinkel in eine horizontale und/oder in eine vertikale Richtung erreicht werden. Hierbei ist dem durchschnittlichen Fachmann bewusst, dass gemäß des Prinzips einer (ebenen) Spiegelreflexion gilt, dass falls die Richtung des einfallenden Lichts unverändert bleibt und der (Mikro-)Spiegel um einen Kippinkel von w gedreht wird, sich der Reflexionswinkel um 2ω ändert (siehe z. B. Pang et al. (2022)). Der durchschnittliche Fachmann ist auch in der Lage, die Auslenkungen des Aktuatorkörpers auf bestimmte Kippwinkel auf jeweilige Anwendungszwecke anzupassen. Vorteilhaft können bei der Gestaltung des Aktuatorkörpers als Mikrospiegel große Gesichtsfelder (englisch: Field of View, FoV) realisiert werden. Mithin eignet sich der MEMS-Aktuator bei einer Vielzahl von Anwendungen, in denen Mikrospiegel eingesetzt werden, z. B. bei LiDAR-Anwendungen und/oder bei Mikroscannern.

Des Weiteren kann auf besonders einfache Weise die Frequenz von Bewegungen und/oder Bewegungsformen des Aktuatorkörpers, insbesondere in Bezug auf Anwendungen von Mikrospiegeln, gesteuert werden. So kann beispielsweise durch die Ansteuerung des Aktuatorarms über ein Steuersignal und/oder die Anbringung von mehreren Aktuatorarmen zwischen der Rahmenstruktur und dem Aktuatorkörper die Frequenz der Bewegung optimiert werden. Mithin resultieren vielfältige Betriebsmodi des Aktuatorkörpers, die sich als nützlich für Mikrospiegel erwiesen haben. So kann der Aktuatorkörper vorteilhaft mit hohen Frequenzen eine Auslenkung erfahren. Das Wirkprinzip des erfindungsgemäßen Aktuatorarms zeichnet sich auch in dieser Hinsicht aus, da mittels eines Steuersignals simultan eine Vielzahl von Aktuatorabschnitten angeregt werden können. Die Trägheit des MEMS-Aktuators wird hierdurch reduziert und es können bei hohen Frequenzen eine unverminderte Präzision erreicht werden.

Beispielsweise kann der Aktuatorkörper mit einer gewünschten Frequenz eine Auslenkung, insbesondere eine Verkippung, um eine Rotationsachse erfahren. Ebenfalls kann der Aktuatorkörper vorteilhaft quasistatisch betrieben werden. Vorteilhafterweise liegen insbesondere beide zuletzt genannte Betriebsmöglichkeiten des bevorzugten MEMS-Aktuators vor.

Weiterhin kann vorteilhaft der Aktuatorkörper mittels des bevorzugten Herstellungsverfahrens besonders zweckmäßig für eine gewünschte Anwendung als Mikrospiegel ausgestaltet werden. So kann auf besonders prozesseffiziente Weise, beispielweise durch bekannte und hinsichtlich der Durchführung einfache Ätzverfahren des Substrats, der Aktuatorkörper bereitgestellt werden sowie Abmessungen und/oder geometrische Formen des Aktuatorkörpers errichtet werden. Zum Beispiel kann der Aktuatorkörper eine Ausdehnung von ca. 0,1 mm bis 5 mm, vorzugsweise 0,5 mm bis 2 mm haben. Folglich kann insbesondere durch die Ausgestaltung des Aktuatorkörpers für eine hohe Lichtausbeute von Mikrospiegeln gewährleistet werden. Der Aktuatorkörper kann im Querschnitt beispielsweise eine Form aufweisen ausgewählt aus einer Gruppe umfassend ein Quadrat, eine Ellipse, einen Kreis, ein Rechteck, ein Dreieck, ein Fünfeck, ein Sechseck, ein Achteck oder eine sonstige regelmäßige oder unregelmäßige geometrische Figur.

Insbesondere ist es bevorzugt, dass der Aktuatorkörper mindestens abschnittsweise eine reflektive Oberfläche aufweist. Besonders bevorzugt ist der Aktuatorkörper selbst als ein Mikrospiegel ausgebildet . Bevorzugt kann der Aktuatorkörper bereits als Mikrospiegel bezeichnet werden, falls dieser bereits eine zumindest abschnittsweise reflektive Oberfläche aufweist. Besonders bevorzugt weist der Aktuatorkörper entlang einer Vorderseite oberflächig eine reflektive Oberfläche aus.

Für die Bereitstellung von mindestens abschnittsweise reflektiven Oberflächen des Aktuatorkörpers liegen bevorzugt mehrere Möglichkeiten vor. Beispielsweise kann der Aktuatorkörper aus einem Substrat gebildet werden, welches bereits die mindestens abschnittsweise reflektive Oberfläche aufweist, sodass vorteilhaft keine weiteren Herstellungsschritte erforderlich sind und sich mithin eine vorteilhafte Prozesseffizienz ergibt. Ebenfalls kann es bevorzugt sein, eine mindestens teilweise reflektive Oberfläche durch einen oder mehrere Beschichtungsprozesse eines entsprechend reflektiven Materials aufzubringen.

Die Reflexion als solche wird bevorzugt durch die Wahl der Materialien reguliert, um die mindestens abschnittsweise reflektive Oberfläche des Aktuatorkörpers zu erzeugen. Die Wahl der Materialien hängt bevorzugt auch damit zusammen, welcher Wellenlängenbereich des Lichts reflektiert werden soll. Bevorzugt kann für die Bereitstellung von einer mindestens abschnittsweisen reflektiven Oberfläche ein Material ausgewählt sein aus einer Gruppe umfassend Aluminium, Silber und/oder Gold. Hinsichtlich der Materialien kann auch von sogenannten Protected Aluminium, Enhanced Aluminium, Protected Silber, Bare und/oder Protected Gold gesprochen werden.

Der Ausdruck "Protected" bezieht sich bevorzugt auf eine zusätzliche Beschichtung durch ein Dielektrikum. Der Begriff "Enhanced" betrifft bevorzugt eine mehrschichtige dielektrische Schicht. Der Begriff "Bare" bezieht sich bevorzugt auf ein ungeschütztes Material. Eine dielektrische Deckschicht auf einem Metall ermöglicht vorteilhafterweise eine bessere Handhabung des Bauteils, erhöht die Haltbarkeit der Metallbeschichtung und bietet Schutz vor Oxidation. Die dielektrische(n) Schicht(en) kann (können) bevorzugt auch so beschaffen sein, dass sie den Reflexionskoeffizienten der Metallbeschichtung in bestimmten Spektralbereichen erhöht. Mithin kann auf besonders einfache Weise durch die Ausgestaltung des Aktuatorkörpers für eine hohe Lichtausbeute durch eine entsprechende Erhöhung des Reflexionskoeffizientens gesorgt werden.

Ist der Aktuatorkörper als Mikrospiegel ausgebildet, kann im erfindungsgemäßen Kontext der MEMS-Aktuator in Kombination mit dem Mikrospiegel als Mikrospiegelaktuator (oder Mikrospiegelaktor) bezeichnet werden.

Der Mikrospiegelaktuator kann als ein räumlicher Lichtmodulator aufgefasst werden. Bevorzugt kann der Mikrospiegelaktuator als ein Mikroscanner fungieren. Der bevorzugte Mikroscanner weist vorteilhaft einen großen optischen Scanbereich auf, der bevorzugt mit hohen (Schwingungs-)Frequenzen betrieben werden kann. Vorteilhaft können eindimensionale, zweidimensionale oder dreidimensionale Objekte optimal gescannt werden. Der Mikrospiegelaktuator kann als Mikroscanner für Projektionsdisplays, Bildaufnahmen, z. B. für technische und medizinische Endoskope, in der Spektroskopie, in der Lasermarkierung und Bearbeitung von Materialien, bei der Objektvermessung / Triangulation, in 3D-Kameras, in der Objekterkennung, beim 1-D- und 2D-Lichtvorhang, in der konfokale Mikroskopie und/oder in der Fluoreszenzmikroskopie eingesetzt werden. Bei Mikroscannern erfolgt die Modulation eines Strahlenbündels bevorzugt an einem kontinuierlich bewegten Mikrospiegel.

Ebenfalls kann es bevorzugt sein, mehrere Mikrospiegelaktuatoren als ein Array anzuordnen, wobei vorzugsweise die einzelnen Mikrospiegel im zeitlichen Verlauf diskret ausgelenkt werden können. Hierdurch wird die Ablenkung von Teilstrahlen bzw. eine phasenschiebende Wirkung Lichtstrahls erzielt. Durch eine entsprechende Arrayanordnung, beispielsweise in Form einer Matrix, kann eine Bildprojektion auf einem geeigneten Projektionsschirm erfolgen.

In einer weiteren bevorzugten Ausführungsform ist der MEMS-Aktuator dadurch gekennzeichnet, dass die Rahmenstruktur aus einem Substrat gebildet wurde, wobei das Substrat ein Material umfasst vorzugsweise ausgewählt aus einer Gruppe umfassend monokristallines Silizium, Polysilizium, Siliziumdioxid, Siliziumcarbid, Siliziumgermanium, Siliziumnitrid, Nitrid, Germanium, Kohlenstoff, Galliumarsenid, Galliumnitrid, Indiumphosphid und/oder Glas.

Die genannten Materialien sind in der Halbleiter- und/oder Mikrosystemtechnik einfach und kostengünstig zu bearbeiten und eignen sich für eine Herstellung im großen Maßstab. Die Rahmenstruktur und/oder weitere Komponenten des bevorzugten MEMS-Aktuators, beispielsweise die Aktuatorabschnitte, der Aktuatorkörper, etc., können aufgrund der Materialien und/oder Herstellungsweisen flexibel hergestellt werden. Insbesondere ist bevorzugt eine Herstellung des bevorzugten MEMS-Aktuators umfassend einen Aktuatorarm zusammen mit einer Rahmenstruktur in einem (Halbleiter-)prozess, bevorzugt auf und/oder aus einem Substrat möglich. Hierdurch wird die Herstellung weiter vereinfacht und verbilligt, sodass kostengünstig ein kompakter und robuster MEMS-Aktuator bereitgestellt werden kann.

In einem weiteren Aspekt betrifft die Erfindung bevorzugt ein Verfahren zur Herstellung eines bevorzugten MEMS-Aktuators umfassend folgende Schritte:
- Ätzung eines Substrats, bevorzugt ausgehend von einer Vorderseite, zur Ausbildung einer Struktur, bevorzugt einer Mäanderstruktur,
- Aufbringung mindestens einer Lage umfassend ein Aktuatormaterial zur Bereitstellung eines Aktuatorarms umfassend zwei oder mehr Aktuatorabschnitte,
- Ätzung des Substrats, bevorzugt ausgehend von einer Rückseite, zur Freilegung des Aktuatorarms,
sodass der Aktuatorarm umfassend die zwei oder mehr Aktuatorabschnitte an einem ersten Ende mit einer durch das Substrat gebildeten Rahmenstruktur und an einem zweiten Ende mit einem Aktuatorkörper verbunden ist, wobei die Aktuatorabschnitte im Wesentlichen senkrecht zu einer Längsachse des Aktuatorarms ausgerichtet sind, sodass durch eine Ansteuerung der Aktuatorabschnitte zu lateralen Wölbungen eine Bewegung des Aktuatorkörpers bewirkbar ist.

Der durchschnittliche Fachmann erkennt, dass technische Merkmale, Definitionen und Vorteile bevorzugter Ausführungsformen des beschriebenen MEMS-Aktuators auch für das beschriebene Herstellungsverfahren gelten und umgekehrt.

Das bevorzugte Herstellungsverfahren hat sich als besonders prozesseffiziente Methode erwiesen, um den bevorzugten MEMS-Aktuator bereitzustellen, da auf gängige Prozessschritte der Halbleiter- und/oder Mikrosystemtechnik zurückgegriffen werden kann. Insbesondere im Kontext zur Herstellung eines MEMS-Aktuators für die Bewegung eines Mikrospiegels hat sich das bevorzugte Verfahren als besonders nützlich erwiesen.

Bevorzugt wird zunächst ein Substrat bereitgestellt. Nach der Bereitstellung des Substrates ist es bevorzugt, die Ätzung des Substrats vorzunehmen, bevorzugt ausgehend von einer Vorderseite, zur Ausbildung einer Struktur, bevorzugt einer Mäanderstruktur. Mit der Ätzung des Substrates ist bevorzugt eine Abtragung des Substratmaterials gemeint, um die Struktur, bevorzugt die Mäanderstruktur, zu bilden. Die Abtragung des Substratmaterials kann in Form von Vertiefungen vorliegen, die beispielsweise Kavitäten am Substrat hinterlassen.

Die Ätzung des Substrates erfolgt bevorzugt durch den Einsatz eines Ätzverfahrens (auch als Ätzprozess bekannt). In bevorzugten Ausführungsform erfolgt die Ätzung des Substrats durch nasschemische Ätzverfahren und/oder Trockenätzverfahren, bevorzugt physikalische und/oder chemische Trockenätzverfahren, besonders bevorzugt durch reaktives lonenätzen und/oder reaktives lonentiefenätzen (Bosch-Prozess), oder durch eine Kombination der vorgenannten Ätzverfahren gebildet werden.

Die vorgenannten Ätzprozesse sind dem Fachmann bekannt. In Abhängigkeit der gewünschten Ausgestaltung der Struktur des Substrats, insbesondere der Mäanderstruktur, können vorteilhafte Verfahren gewählt werden, um eine effiziente Durchführung zu gewährleisten.

Nach der Bereitstellung einer Struktur in dem Substrat, bevorzugt einer Mäanderstruktur, ist die Aufbringung mindestens einer Lage umfassend ein Aktuatormaterial zur Bereitstellung des Aktuatorarms umfassend zwei oder mehr Aktuatorabschnitte bevorzugt.

Vorzugsweise erfolgt die die Aufbringung der mindestens einen Lage umfassend das Aktuatormaterial durch den Einsatz eines Beschichtungsverfahrens innerhalb einer Beschichtungsanlage. Das Beschichtungsverfahren kann beispielsweise ausgewählt sein aus einer Gruppe umfassend Sprühbeschichtung, Nebelbeschichtung und/oder Dampfbeschichtung.

Vorzugsweise erfolgt die Beschichtung innerhalb einer Beschichtungsanlage, die eine physikalische Beschichtungsanlage oder chemische Beschichtungsanlage, bevorzugt plasmagestützte chemische Beschichtungsanlage, Niederdruck-chemische und/oder Epitaxie-Beschichtungsanlage sein kann.

Weiterhin ist es bevorzugt, dass eine Ätzung des Substrats, bevorzugt ausgehend von einer Rückseite, zur Freilegung des Aktuatorarms erfolgt. Zur Freilegung des Aktuatorarms kann bevorzugt ein oder mehrere der aufgezählten Ätzverfahren eingesetzt werden.

Mithin liegt nach dem bevorzugten Verfahren der Aktuatorarm umfassend die zwei oder mehr Aktuatorabschnitte vor, der an einem ersten Ende mit einer durch das Substrat gebildeten Rahmenstruktur und an einem zweiten Ende mit einem Aktuatorkörper verbunden ist, vor. Die Aktuatorabschnitte sind bevorzugt im Wesentlichen senkrecht zu einer Längsachse des Aktuatorarms ausgerichtet sind, sodass durch eine Ansteuerung der Aktuatorabschnitte eine Bewegung des Aktuatorkörpers bewirkbar ist.

Bevorzugt wird der Aktuatorkörper aus einem Stück des Substrats gebildet, wobei vorzugsweise die Bildung des Aktuatorkörpers durch eine entsprechende Ätzung des Substrats erfolgt. Weiterhin kann es bevorzugt sein, den Aktuatorkörper zu funktionalisieren, bevorzugt durch eine mindestens abschnittsweise Auftragung bzw. Beschichtung mit einem reflektiven Material, sodass der Aktuatorkörper als Mikrospiegel vorliegt.

In einer weiteren bevorzugten Ausführungsform ist das Verfahren dadurch gekennzeichnet, dass durch Ätzung des Substrats, bevorzugt ausgehend von einer Vorderseite, eine Mäanderstruktur gebildet wird, wobei Bereiche der Mäanderstruktur des Substrates, welche der Bildung der zwei oder mehr Aktuatorabschnitte dienen, orthogonal zur Oberfläche des Substrats orientiert sind.

Die Abschnitte des Substrats, die durch die Ätzung nicht abgetragen werden, dienen bevorzugt für die Bereitstellung der Mäanderstruktur. Weiterhin ist es bevorzugt, auf die Mäanderstruktur mindestens eine Lage umfassend ein Aktuatormaterial aufzubringen. Bevorzugt werden zwei Lagen aufgebracht, wobei die zwei Lagen eine Lage umfassend ein Aktuatormaterial und eine mechanische Stützschicht oder zwei Lagen umfassend ein Aktuatormaterial sein können. Durch die Aufbringung zweier Lagen wird bevorzugt der mechanische Bimorph gebildet, wobei ein Aktuatorabschnitt als mechanischer Bimorph aufzufassen ist und dieser durch die Ätzung vertikal zur Substratoberfläche angeordnet ist. Durch eine bevorzugte Ätzung, vorzugsweise ausgehend von einer Rückseite, erfolgt die Freistellung des Aktuatorarms.

Die Bereiche einer Mäanderstruktur, an welchen die Aktuatorabschnitte (vertikale Abschnitte) des Aktuatorarms gebildet werden, liegen damit bevorzugt im Wesentlichen vertikal zur Substratoberfläche aus, aus welcher die Rahmenstruktur und/oder der Aktuatorarm gebildet wurde. Im fertigen MEMS-Aktuator erstreckt sich der Aktuatorarm bevorzugt im Wesentlichen horizontal zur (ursprünglichen) Substratoberfläche (z. B. eines Wafers), während die Aktuatorabschnitte vertikal zur (ursprünglichen) Substratoberfläche angeordnet sind.

Die Erfindung soll im Folgenden unter Verweis auf weitere Figuren und Beispiele erläutert werden. Die Beispiele und Figuren dienen der Illustration bevorzugter Ausführungsformen der Erfindung, ohne auf diese beschränkt zu sein.

### FIGUREN

### Kurzbeschreibunq der Figuren

- **Fig. 1**: Schematische Darstellung einer bevorzugten Ausführungsform eines MEMS-Aktuators
- **Fig. 2**: Schematische Darstellung einer bevorzugten Ausführungsform eines MEMS-Aktuators mit einem Aktuatorarm für eine Auslenkung bzw. Verkippung des Aktuatorkörpers
- **Fig. 3**: Schematische Darstellung einer weiteren bevorzugten Ausführungsform eines MEMS-Aktuators mit einem Aktuatorarm für eine Verkippung des Aktuatorkörpers um eine ortsfeste Drehachse (Fixierungsmittel)
- **Fig. 4**: Schematische Darstellung einer weiteren bevorzugten Ausführungsform eines MEMS-Aktuators mit zwei gegenüberliegenden Aktuatorarmen für eine vertikale Translation des Aktuatorkörpers
- **Fig. 5**: Simulationen von bevorzugten Ausführungsform eines MEMS-Aktuators

### Detaillierte Beschreibung der Figuren

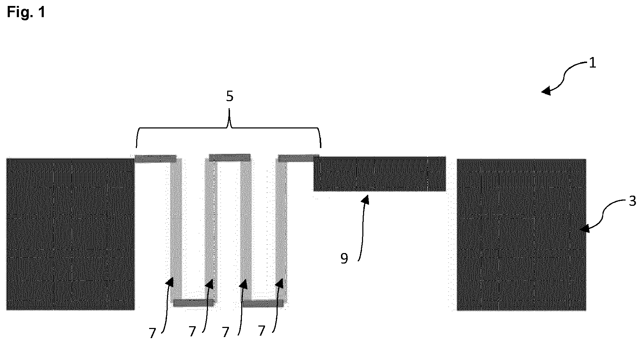

Fig. 1 stellt eine schematische Darstellung einer bevorzugten Ausführungsform eines MEMS-Aktuators **1** dar.

Der MEMS-Aktuator **1** umfasst eine Rahmenstruktur **3** und einen Aktuatorarm **5**. Der Aktuatorarm **5** ist an einem ersten Ende mit der Rahmenstruktur **3** und an einem zweiten Ende mit einem Aktuatorkörper **9** verbunden. Weiterhin weist der Aktuatorarm **5** eine Mäanderstruktur umfassend Aktuatorabschnitte **7** auf, wobei die Aktuatorabschnitte **7** im Wesentlichen senkrecht zu einer Längsachse des Aktuatorarms **5** ausgerichtet sind. Darüber hinaus umfasst der Aktuatorarm **5** mindestens eine Lage aus einem Aktuatormaterial (nicht eingezeichnet), sodass durch eine Ansteuerung der Aktuatorabschnitte **7** eine Bewegung des Aktuatorkörpers **9** bewirkbar ist.

Der MEMS-Aktuator **1** erreicht vorteilhafterweise besonders hohe Auslenkungen, insbesondere in Form von hohen Kippwinkeln des Aktuatorkörpers **9**. Die vorteilhafte Erzielung hoher Kippwinkel des Aktuatorkörpers **9** wird insbesondere durch die Ausgestaltung des Aktuatorarms **5** ermöglicht, insbesondere durch die Mäanderstruktur umfassend Aktuatorabschnitte **7**, die im Wesentlichen senkrecht zur Längsachse des Aktuatorarms **5** ausgerichtet sind.

Durch die Mäanderstruktur ergibt sich eine höhere Strecke und damit ein höheres Moment (Produkt aus Kraft und Weg) und folglich auch eine höhere Auslenkbarkeit des Aktuatorkörpers **9**, insbesondere in Form eines höheren Kippwinkels.

Der vorteilhafte Effekt des Erreichens höherer Auslenkungen des Aktuatorkörpers **9**, insbesondere höherer Kippwinkel, ist nützlich für eine Vielzahl von Anwendungen. So eignet sich der MEMS-Aktuator **1** besonders gut für die Bewegung und/oder Verkippung von Mikrospiegeln. Vorteilhaft kann der MEMS-Aktuator **1** mit einer Vielzahl von Wirkungsweisen betrieben werden. Weiterhin kann vorteilhaft ein potentieller Nutzer des bevorzugten MEMS-Aktuators **1** ein Wirkungsprinzip aus einer Vielzahl von physikalische Prinzipien auswählen, beispielsweise eine Ansteuerung durch ein elektrisches oder thermisches Signal, um die Bewegung des Aktuatorkörpers **9** zu bewirken. Die Ausnutzung eines Aktuatorarmes **5** mit einer Mäanderstruktur zur Bewegung des Aktuatorkörpers **9** ist somit nicht auf bestimmte Aktuatorprinzipien beschränkt.

Des Weiteren zeichnet sich der MEMS-Aktuator **1** durch eine prozesseffiziente Herstellbarkeit aus. Der MEMS-Aktuator **1** ist mit gängigen Methoden der Mikrosystem- und/oder Halbleitertechnik bereitstellbar, insbesondere die Strukturierung der Mäanderstruktur sowie die Ausgestaltung des Aktuatorarms **5**. Besonders vorteilhaft ist, dass der MEMS-Aktuator **1** aus einem Substrat und damit innerhalb einer einzelnen Prozessabfolge hergestellt werden kann. So können beispielsweise Komponenten wie die Rahmenstruktur **3**, der Aktuatorarm **5** umfassend Aktuatorabschnitte **7** und/oder der Aktuatorkörper **9** aus einem Substrat gebildet werden.

Fig 2 A-B bildet eine schematische Darstellung eines bevorzugten MEMS-Akuators **1** mit einem Aktuatorarm **5** sowie dessen Verwendung für eine Auslenkung bzw. Verkippung des Aktuatorkörpers **9**. Die Fig. 2 A-B zeigt zwei Phasen einer Verkippung des Aktuatorkörpers **9**. In Fig. 2 A wird der Aktuatorkörper in Richtung einer Vorderseite ("nach oben") verkippt, während in Fig. 2 B der Aktuatorkörper **9** in Richtung einer Rückseite ("nach unten") verkippt wird. Hierbei werden hohe Auslenkungen des Aktuatorkörpers **9**, insbesondere hohe Kippwinkel, durch Ansteuerung der Aktuatorabschnitte **7** erlangt. Der Aktuatorkörper **9** kann um mindestens 10°, bevorzugt um mindestens 20°, besonders bevorzugt um mindestens 40°, besonders bevorzugt um mindestens 60°verkippt werden. Da der Aktuatorkörper **9** nicht fixiert ist, erfolgt mit der Verkippung bzw. Rotation des Aktuatorkörpers **9** gleichzeitig eine vertikale Translation aus der Ebene.

Sofern eine derartige Translationsbewegung nicht gewünscht ist, kann es bevorzugt sein, durch ein Fixierungselement den (Translations-)Freiheitsgrad des Aktuatorkörpers **9** einzuschränken.

In Fig. 3 A-B wird eine schematische Darstellung einer bevorzugten Ausführungsform eines MEMS-Aktuators **1** abgebildet, welcher ein Fixierungselement **11** aufweist, welches mit dem Aktuatorkörper **9** verbunden ist. Durch das Fixierungselement **11**wird eine Translation des Aktuatorkörpers **9** in einer vertikalen Richtung unterbunden, sodass durch die Anlegung des Steuersignals der Aktuatorkörper **9** entlang eines im Wesentlichen ortsfesten Drehpunktes und/oder einer Drehachse verkippbar ist. Analog zu Fig. 2 A-B wird in Fig. 3 A der Aktuatorkörper **9** in Richtung einer Vorderseite verkippt, während in Fig. 3 B der Aktuatorkörper **9** in Richtung einer Rückseite verkippt wird. Im Gegensatz zur Ausführungsform der Fig. 2 A-B erfolgt jedoch keine überlagerte vertikale Translationsbewegung. Die Anpassung der Verkippung wird durch Fixierungselement **11** erlangt.

Des Weiteren liegt am ersten Ende des Aktuatorarms **5** ein mechanisch flexibles Verbindungsstück **13** vor, welches mit der Rahmenstruktur **3** verbunden ist. Durch das mechanisch flexible Verbindungsstück **13** liegt vorteilhaft ein verminderter mechanischer Widerstand an dem ersten Ende und damit an der Verbindungsstelle des Aktuatorarms **5** mit der Rahmenstruktur **3** vor, sodass die Bewegung des Aktuatorkörpers **9** mit besonders geringem mechanischen Widerstand erfolgt. Ein mechanisch flexibles Verbindungsstück **13** zeichnet sich neben einer Flexibilität bevorzugt durch elastische Eigenschaften aus, um eine Rückstellkraft auf eine Vorzugsposition zu gewährleisten. Bevorzugt kann es sich bei einem mechanisch flexiblen Verbindungsstück **13** um eine MEMS-Feder handeln.

Fig. 4 stellt eine weitere bevorzugte Ausführungsform eines MEMS-Aktuators **1** dar.

Hierbei umfasst der MEMS-Aktuator **1** einen Aktuatorkörper **9**, der über zwei Aktuatorarme **5** mit der Rahmenstruktur **3** verbunden vorliegt. Die zwei Aktuatorarme **5** liegen in einer Ebene vor und schließen einen Winkel von im Wesentlichen 180° ein. Die Anbringung zweier Aktuatorarme **5**, insbesondere entlang einer Ebene innerhalb eines Winkelbereichs von 180°, erlaubt insbesondere auf effiziente Weise eine Auslenkung des Aktuatorkörpers **9** aus der Ebene. Die Anbringung zweier Aktuatorarme **5** von im Wesentlichen 180° zueinander zeichnet sich durch eine im Wesentlichen horizontale Erstreckung der Aktuatorarme **5** aus, wobei mittig der Aktuatorkörper **9** vorliegt.

Weiterhin liegt sowohl am ersten Ende als auch am zweiten Ende der Aktuatorarme **5** jeweils ein mechanisch flexibles Verbindungsstück **13** vor, sodass die Auslenkung und/oder Bewegung des Aktuatorkörpers **9** während der Ansteuerung begünstigt wird.

In Fig. 5 A-B werden Simulationen des MEMS-Aktuators **1** gezeigt, insbesondere während einer Auslenkung des Aktuatorarms **5**. Die abgebildeten Simulationsergebnisse basieren auf einer Finite-Elemente-Methode.

In Fig. 5 A wird der Aktuatorarm **5** aus der Fig. 2 ohne das Vorhandensein des Aktuatorkörpers **9** simuliert. Hierbei wird ein Aktuatorarm **5** mit Mäanderstruktur und 8 Aktuatorabschnitten dargestellt, welcher an einem ersten Ende (in der Fig. 5 A links) an einer Rahmenstruktur (nicht gezeigt) fixiert vorliegt. Das zweite Ende des Aktuatorarms - an welchem ein Aktuatorkörper anbringbar ist - ist nicht fixiert. In der simulierten Bewegung wird das zweite Ende in positiver y-Richtung (vertikale Richtung) und negativer x-Richtung (horizontale) ausgelenkt bzw. translatiert, während eine Verkippung erfolgt. Die feste Einspannung am ersten Ende ist links am blauen Ende (Verschiebung = 0) gezeigt. Der Kippwinkel beträgt hier ca. 8°.

An der Simulation ist zu erkennen, dass während einer Ansteuerung die einzelnen Aktuatorabschnitte verschiebbar sind, insbesondere an vertikalen endseitigen Abschnitten der Aktuatorabschnitte. Demzufolge ist der mechanische Widerstand des Aktuatorarms, insbesondere der Aktuatorabschnitte, geringer, als wenn der Aktuatorarm durch eine ebene bzw. geradlinige Struktur bereitgestellt werden würde, sodass hohe Auslenkungen erreicht werden können.

In Fig. 5 B wird ein MEMS-Aktuator 1 gemäß der Vorzugsform der Fig. 4 simuliert. Der modellierte Aktuatorarm **5** ist mit seinem ersten Ende fest eingespannt (Verschiebung = 0). An seinem zweiten Ende ist ein Aktuatorkörper **9** anbringbar, welche zudem wie in Fig. 4 illustriert auf einer gegenüberliegenden Seite von einem zweiten Akuatorarms **5** gehalten wird. Die vertikale Verschiebung des Aktuatorkörpers **9** beträgt in der Simulation in y-Richtung ca. 10 µm.

### LITERATURVERZEICHNIS

Algamili, Abdullah Saleh, et al. "A review of actuation and sensing mechanisms in mems-based sensor devices." Nanoscale research letters 16.1 (2021): 1-21.

Wang, Dingkang, Connor Watkins, and Huikai Xie. "MEMS mirrors for LiDAR: a review." Micromachines 11.5 (2020): 456.

Katal, Goldy, Nelofar Tyagi, and Ashish Joshi. "Digital light processing and its future applications." International journal of scientific and research publications 3.1 (2013): 2250-3153.

Lee, Benjamin. "Introduction to ±12 degree orthogonal digital micromirror devices (dmds)." Texas Instruments (2008): 2018-02.

Holmström, Sven TS, Utku Baran, and Hakan Urey. "MEMS laser scanners: a review." Journal of Microelectromechanical Systems 23.2 (2014): 259-275.

Pang, Yajun, et al. "Design Study of a Large-Angle Optical Scanning System for MEMS LIDAR." Applied Sciences 12.3 (2022): 1283.

### BEZUGSZEICHENLISTE

- 1: MEMS-Aktuator
- 3: Rahmenstruktur
- 5: Aktuatorarm
- 7: Aktuatorabschnitt
- 9: Aktuatorkörper
- 11: Fixierungselement
- 13: Verbindungsstück

## Patentansprüche

1. MEMS-Aktuator (1) umfassend eine Rahmenstruktur (3) und mindestens einen Aktuatorarm (5), wobei der Aktuatorarm (5) an einem ersten Ende mit der Rahmenstruktur (3) und an einem zweiten Ende mit einem Aktuatorkörper (9) verbunden ist,
**dadurch gekennzeichnet, dass**
der mindestens eine Aktuatorarm (5) eine Mäanderstruktur umfassend zwei oder mehr Aktuatorabschnitte (7) aufweist, wobei die zwei oder mehr Aktuatorabschnitte (7) im Wesentlichen senkrecht zu einer Längsachse des Aktuatorarms (5) ausgerichtet sind und mindestens eine Lage aus einem Aktuatormaterial umfassen und wobei durch eine Ansteuerung der zwei oder mehr Aktuatorabschnitte (7) eine Bewegung des Aktuatorkörpers (9) bewirkbar ist.

2. MEMS-Aktuator (1) nach dem vorherigen Anspruch
**dadurch gekennzeichnet, dass**
die Bewegung des Aktuatorkörpers (9) eine Translation, Rotation, Torsion und/oder Verkippung umfasst.

3. MEMS-Aktuator nach einem oder mehreren der vorherigen Ansprüche
**dadurch gekennzeichnet, dass**
die zwei oder mehr Aktuatorabschnitte (7) durch Aufbringung mindestens einer Lage umfassend ein Aktuatormaterial auf eine Mäanderstruktur eines Substrates gebildet wurden, wobei bevorzugt Bereiche der Mäanderstruktur des Substrates zur Bildung der zwei oder mehr Aktuatorabschnitte (7) orthogonal zur Oberfläche des Substrats orientiert waren.

4. MEMS-Aktuator (1) nach einem oder mehreren der vorherigen Ansprüche
**dadurch gekennzeichnet, dass**
die zwei oder mehr Aktuatorabschnitte (5) mindestens zwei Lagen umfassen,
wobei bevorzugt eine Lage ein Aktuatormaterial und eine zweite Lage ein mechanisches Stützmaterial umfasst und/oder wobei beide Lagen (11) ein Aktuatormaterial umfassen.

5. MEMS-Aktuator (1) nach einem oder mehreren der vorherigen Ansprüche
**dadurch gekennzeichnet, dass**
das Aktuatormaterial ein piezoelektrisches Material, ein Polymer Piezoelectrical Material, elektroaktive Polymere (EAP) und/oder ein thermosensitives Material umfasst.

6. MEMS-Aktuator (1) nach einem oder mehreren der vorherigen Ansprüche
**dadurch gekennzeichnet, dass**
der Aktuatorarm (5) mit mindestens einer Elektrode kontaktiert vorliegt und eine Ansteuerung der Aktuatorabschnitte (7) zu lateralen Wölbungen oder Auslenkungen durch ein elektrisches Steuersignal erfolgt.

7. MEMS-Aktuator (1) nach einem oder mehreren der vorherigen Ansprüche
**dadurch gekennzeichnet, dass**
der MEMS-Aktuator (1) ein Fixierungselement (11) aufweist, welches mit dem Aktuatorkörper (9) verbunden ist, sodass durch die Anlegung des Steuersignals der Aktuatorkörper (9) entlang eines Drehpunktes und/oder einer Drehachse verkippbar ist.

8. MEMS-Aktuator (1) nach einem oder mehreren der vorherigen Ansprüche
**dadurch gekennzeichnet, dass**
das erste Ende des Aktuatorarms (5) über ein mechanisch starres oder flexibles Verbindungsstück (13) mit der Rahmenstruktur (3) verbunden vorliegt.

9. MEMS-Aktuator (1) nach einem oder mehreren der vorherigen Ansprüche
**dadurch gekennzeichnet, dass**
durch Ansteuerung der zwei oder mehr Aktuatorabschnitte (7) der Aktuatorkörper (9) um mindestens 10°, bevorzugt um mindestens 20°, besonders bevorzugt um mindestens 40°, besonders bevorzugt um mindestens 60° um einen Drehpunkt verkippbar ist.

10. MEMS-Aktuator (1) nach einem oder mehreren der vorherigen Ansprüche
**dadurch gekennzeichnet, dass**
der mindestens eine Aktuatorarm (5) mehr als 3, 4, 5, 10, 15, 20, 30, 40, 50, 100 oder mehr Aktuatorabschnitte (7) umfasst.

11. MEMS-Aktuator (1) nach einem oder mehreren der vorherigen Ansprüche
**dadurch gekennzeichnet, dass**
der Aktuatorkörper (9) über ein, zwei, drei oder vier Aktuatorarme (5) mit der Rahmenstruktur (3) verbunden vorliegt, wobei die ein, zwei, drei oder vier Aktuatorarme (5) vorzugsweise in einer Ebene vorliegen.

12. MEMS-Aktuator (1) nach einem oder mehreren der vorherigen Ansprüche
**dadurch gekennzeichnet, dass**
der Aktuatorkörper (9) über zwei Aktuatorarme (5) mit der Rahmenstruktur verbunden vorliegt, wobei die zwei Aktuatorarme (5) in einer Ebene vorliegen und in der Ebene einen Winkel von im Wesentlichen 90° oder einen Winkel von im Wesentlichen 180° einschließen.

13. MEMS-Aktuator (1) nach einem oder mehreren der vorherigen Ansprüche
**dadurch gekennzeichnet, dass**
der Aktuatorkörper (9) mindestens abschnittsweise eine reflektive Oberfläche aufweist, besonders bevorzugt als einen Mikrospiegel ausgebildet ist.

14. Verfahren zur Herstellung eines MEMS-Aktuators (1) nach einem oder mehreren der vorherigen Ansprüche umfassend folgende Schritte:
- Ätzung eines Substrats, bevorzugt ausgehend von einer Vorderseite, zur Ausbildung einer Struktur, bevorzugt einer Mäanderstruktur,
- Aufbringung mindestens einer Lage umfassend ein Aktuatormaterial zur Bereitstellung eines Aktuatorarms (5) umfassend zwei oder mehr Aktuatorabschnitte (7),
- Ätzung des Substrats, bevorzugt ausgehend von einer Rückseite, zur Freilegung des Aktuatorarms (5),
sodass der Aktuatorarm (5) umfassend die zwei oder mehr Aktuatorabschnitte (7) an einem ersten Ende mit einer durch das Substrat gebildeten Rahmenstruktur (3) und an einem zweiten Ende mit einem Aktuatorkörper (9) verbunden ist, wobei die Aktuatorabschnitte (7) im Wesentlichen senkrecht zu einer Längsachse des Aktuatorarms (5) ausgerichtet sind, sodass durch eine Ansteuerung der Aktuatorabschnitte (7) zu lateralen Wölbungen eine Bewegung des Aktuatorkörpers (9) bewirkbar ist.

15. Verfahren nach dem vorherigen Anspruch
**dadurch gekennzeichnet, dass**
durch Ätzung des Substrats, bevorzugt ausgehend von einer Vorderseite, eine Mäanderstruktur gebildet wird, wobei Bereiche der Mäanderstruktur des Substrates, welche der Bildung der zwei oder mehr Aktuatorabschnitte (7) dienen, orthogonal zur Oberfläche des Substrats orientiert sind.
